# EUROPEAN PATENT SPECIFICATION

(11) **EP 3 959 526 B1**
(45) Date of publication and mention of the grant of the patent: **16.10.2024**
(21) Application number: 20723501.1
(22) Date of filing: 24.04.2020
(51) Int. Cl.: G01R 33/3415, G01R 33/343, G01R 33/34, G01R 33/341

(54) **RADIOFREQUENCY COIL**
HOCHFREQUENZSPULE
BOBINE RADIOFRÉQUENCE

(30) Priority: 26.04.2019 GB 201905844
(43) Date of publication of application: 02.03.2022
(73) Proprietor: Oxford University Innovation Limited, Oxford, OX2 0JB (GB)
(72) Inventor: ZHOU, Tony, Oxford OX2 0JB (GB); LAU, Justin, Oxford OX2 0JB (GB); MILLER, Jack, Oxford OX2 0JB (GB); TYLER, Damian, Oxford OX2 0JB (GB); RANDELL, Chris, Oxford OX2 0JB (GB)
(74) Representative: Dehns
(86) International application number: PCT/GB2020/051022
(87) International publication number: WO 2020/217069

(56) References cited:
- EP-A2- 1 486 793
- US-A- 6 023 166
- US-A1- 2005 253 582
- US-A1- 2010 301 862
- US-A1- 2012 286 786
- US-A1- 2015 061 676
- US-A1- 2016 320 464
- ZHOU T., LAU J., TYLER A., RANDELL C., MILLER J., TYLER D.: "Multilayered radiofrequency coil design for X-nuclei imaging", INTERNATIONAL SOCIETY FOR MAGNETIC RESONANCE IN MEDICINE, ISMRM, 2030 ADDISON STREET, 7TH FLOOR, BERKELEY, CA 94704 USA, no. 2520, 26 April 2019 (2019-04-26), XP040709906

## Description

This invention relates to a radiofrequency coil, in particular to a multilayer radiofrequency coil for use in a magnetic resonance imaging (MRI) scanner.

Magnetic resonance imaging (MRI) scanners are used to perform magnetic resonance measurements of a sample, for example magnetic resonance imaging or spectroscopy of a human or animal subject, typically to investigate the anatomy and physiology of the subject, e.g. to detect pathologies or abnormalities. MRI scanners include a large primary magnet that applies a static magnetic field over the scanning volume to polarise the nuclear spins of the sample being scanned, a gradient magnet that applies a magnetic field having a linear variation across the scanning volume to allow spatial localisation, and a radio frequency (RF) system to transmit an oscillating magnetic field (to excite nuclei in the sample) and receive RF radiation (from the subsequent relaxation of the excited nuclei).

The RF system is typically provided in part as a "volume" transmit coil in the main body of the scanner that surrounds the bore of the scanner into which the sample to be scanned is placed, and in part as a "surface" receive coil which is placed over the region (e.g. part of the patient) of the sample to be scanned. The transmit coil operates to transmit the oscillating magnetic field to excite nuclei in the sample. The receive coil operates to inductively detect the precessing magnetisation of the excited nuclei in the sample.

Such a "volume" transmit coil is able to provide a homogeneous magnetic field but requires RF power amplifier(s) to provide the necessary strength of the oscillating magnetic field for exciting the nuclei in the sample. In cases where multi-nuclear volume coils exist, when it is desired to perform multi-nuclear imaging (i.e. excite nuclei other than hydrogen, such as carbon-13 and sodium-23), the conventional multi-nuclear RF amplifier is required to be broadband, that is, to be able to amplify RF frequencies that cover all primary non-hydrogen nuclei, and as such typically exhibits lower output power compared to a narrowband proton-only amplifier. This power is deposited as RF energy into the subject, which may cause localised heating leading to a safety limit, known as the Specific Absorption Rate (SAR).

Additionally, a "surface" coil may also be used in both transmit and receive mode, as this may offer greater sensitivity owing to the lower intrinsic coil noise, lower sample noise contribution and proximity to the sample, owing to its physically smaller design. Such "surface" coils are, however, often not able to generate a magnetic field that penetrates the sample to a sufficient depth and may generate a less homogeneous magnetic field than a corresponding "volume" transmit coil.

US 2016/320464, US 2005/253582 and US 6,023,166 disclose different radiofrequency surface coils for use in magnetic resonance imaging.

The present invention aims to provide an improved radiofrequency surface coil. When viewed from a first aspect, the invention provides a radiofrequency surface coil in accordance with claim 1.

The present invention provides a radiofrequency surface coil (herein referred to as a radiofrequency coil) for use in magnetic resonance, e.g. for use in or with an MRI scanner. The radiofrequency coil is arranged to either transmit an oscillating magnetic field or receive an oscillating magnetic field, or to both transmit and receive oscillating magnetic fields.

The radiofrequency coil includes a continuous conducting path which is made up of multiple conducting elements that are joined together to form the path. The continuous conducting path is conducting to an applied or induced radiofrequency alternating current. Each conducting element, which bounds (e.g. at least partially surrounds) an area defined by the conducting element (e.g. the conducting element forms at least part of the perimeter of the area), is connected to another conducting element (or, e.g. to two other conducting elements).

The conducting elements that form the continuous conducting path of the radiofrequency coil are arranged (positioned) relative to each other in substantially parallel surfaces (with, e.g., each conducting element arranged (lying) in a respective surface, such that the plurality of conducting elements are (in at least preferred embodiments) arranged in a plurality of respective substantially parallel surfaces that may, for example, be deformed around anatomical surfaces). The conducting elements are also arranged such that the area bounded by a conducting element lying in one surface overlaps with at least 20% of the area bounded by the conducting element lying in another substantially parallel surface.

It will thus be appreciated that providing a significant overlap between the elements of the coil helps to provide a radiofrequency coil that can generate an increased magnetic flux density for transmitting into a sample and/or receive an emitted magnetic field with an improved sensitivity. This helps to provide a radiofrequency coil for use in an MRI scanner which may be able to be used for exciting and/or detecting a variety of different nuclei.

In particular, the radiofrequency coil may be able to provide an increased amount of magnetic flux density for the (e.g. amplified) power used to drive the radiofrequency coil, may be able to transmit the generated magnetic field deeper into the sample to be scanned and may be able to generate a more homogeneous magnetic field for transmitting into the sample to be scanned, all over a larger common area. All of these advantages are enabled by the larger common area, owing to the significant overlap between the conducting elements of the coil, that the radiofrequency coil of the present invention provides.

Use of such a radiofrequency coil may also help to confine the magnetic field to a particular region of the sample to be scanned (when the radiofrequency coil is being used in a transmit mode), thus helping to reduce the energy deposition and thus the SAR (e.g. for a particular strength of the magnetic field) that is experienced by the sample being scanned, particularly for parts of the sample that are not of interest to the scan (for example, medical implants that may be at risk of being affected by the magnetic field).

When the radiofrequency coil is used for receiving an oscillating magnetic field, e.g. from the precessing magnetisation of nuclei excited by an oscillating magnetic field, the arrangement of the radiofrequency coil enables the detection of the magnetic field from a greater penetration depth in the sample being scanned and helps the radiofrequency coil to be more sensitive (and thus have an improved detection efficiency), again owing to the plurality of conducting elements arranged over a relatively large common area.

The radiofrequency coil may be suitable for use in any suitable and desired magnetic resonance imaging system (e.g. MRI scanner), with particular embodiments suited to a particular anatomical geometry or substantially extant MRI system. The radiofrequency coil may be used as a volume coil. The radiofrequency coil comprises a radiofrequency surface coil. A surface coil typically requires less power and hence may require a less powerful RF amplifier than a corresponding volume coil. Such a surface coil may therefore contribute less to SAR than a corresponding volume coil.

In one embodiment the radiofrequency coil is arranged only to transmit an oscillating magnetic field. In another embodiment the radiofrequency coil is arranged only to receive an oscillating magnetic field. In another embodiment the radiofrequency coil is arranged both to transmit and receive oscillating magnetic fields. Providing a radiofrequency coil that is able to both transmit and receive oscillating magnetic fields means that the radiofrequency coil can be used in an MRI system that does not need separate transmit and receive coils. In addition, when embodied in the transmit and receive mode of operation, an improved penetration and homogeneity of the magnetic field is achieved, for a given amplification power, whilst the energy deposition in the sample being scanned is reduced (owing to the localised magnetic field which can thus be better targeted to the area of the sample being scanned), and a good detection sensitivity may also be achieved.

The oscillating radiofrequency magnetic field (e.g. B₁) that is generated and transmitted, and/or received and detected by the radiofrequency coil may be any suitable and desired oscillating magnetic field. In one embodiment, the radiofrequency coil is arranged to generate and transmit an oscillating magnetic field having a frequency, for example, between 3 kHz and 1 GHz, e.g. between 300 kHz and 600 MHz, e.g. between 30 MHz and 300 MHz.

Depending on the particular nuclei to be excited and scanned by the oscillating magnetic field, a different frequency oscillating magnetic field may be used, e.g. for a particular strength of the static magnetic field applied. For example, for scanning hydrogen at 3 Tesla, an oscillating magnetic field having a frequency of approximately 120 MHz may be required; for scanning carbon-13 at 3 Tesla, an oscillating magnetic field having a frequency of approximately 30 MHz may be required; for scanning carbon-13 at 7 Tesla, an oscillating magnetic field having a frequency of approximately 75 MHz may be required; and for scanning sodium-23 at 7 Tesla, an oscillating magnetic field having a frequency of approximately 79 MHz may be required.

In one embodiment the radiofrequency coil is arranged to generate and transmit an oscillating magnetic field having a magnetic field strength (on the central axis of the radiofrequency coil at a distance equal to the nominal radius of the radiofrequency coil) of less than 10 mT, e.g. less than 1 mT, e.g. less than 100 µT.

The conducting elements may be provided in any suitable and desired way to form the continuous conducting path. In one embodiment, the conducting elements comprise copper tracks, e.g. formed on a substrate such as a printed circuit board, e.g. deposited via photolithography or other such construction techniques. In another embodiment, the conducting elements comprise tubes. The tubes may have any suitable and desired cross-section shape, e.g. circular, e.g. oval, e.g. square, e.g. rectangle, e.g. polygon, e.g. semi-circle, e.g. crescent. Thus, preferably the conducting elements are elongate (having a length (significantly) greater than their width (and their thickness)). The tubes may have an outer wall that extends around the full perimeter of their cross-section (e.g. closed tubes) or around a portion of the perimeter of their cross-section (e.g. open tubes, e.g. when the cross-section is a semi-circle or crescent).

In embodiments where the conducting elements comprise (printed) tracks, e.g. copper tracks, the thickness of the tracks may be any suitable and desired thickness. The (printed) tracks may be approximately rectangular in cross-section. The thickness of the tracks may be between 10 µm and 150 µm, e.g. between 17.5 µm to 140 µm, e.g. 70 µm, e.g. approximately 35 µm. In some embodiments, the thickness of the copper tracks are selected from the list comprising approximately 17.5 µm, approximately 35 µm and approximately 70 µm.

Therefore, in embodiments in which the conducting elements comprise copper tracks, the conducting elements are preferably vertically thin. This helps to place the effective centre of the radiofrequency coil is closer to the sample for increased penetration depth.

In embodiments in which the conducting elements comprise (e.g. cylindrical with a circular cross-section) tubes, the wall thickness of the tubes may be any suitable or desired width. The wall thickness of the tubes may be between 1 µm and 2 mm, e.g. 500 µm and 1.5 mm, e.g. 0.1 mm and 1 mm, e.g. 0.5 mm. The bore of the tubes (defined by the tube wall) may be filled with any suitable or desirable material, e.g. a dieletric such as air. In some embodiments the tubes may be filled with a solid material, e.g. a metal to form a bi-metallic tube. In some embodiments the tubes may have a substantially uniform density over the cross-section shape, e.g. the tubes are formed by one solid material, e.g. a solid filled metal cylinder.

Embodiments with conducting elements that are (cylindrical) tubes results in the conductor surface area being increased by a factor of π when compared to an equivalently sized (printed) track conducting element. This increased surface area helps to reduce the current crowding at crossing points of adjacent conducting elements. This reduction in resistance results from proximity effects between two close conductors (and thus helps to maintain the homogeneity and strength of the generated magnetic field). Reducing the radiofrequency coil resistance helps to provide an increased coil sensitivity and an increased signal-to-noise ratio (SNR). This helps to provide an improved receive performance when the radiofrequency coil is configured to receive.

The conducting elements (e.g. copper tracks or tubes) may be any suitable and desired width (the dimension perpendicular to the direction in which the conducting element extends along the continuous conducting path and perpendicular to the thickness of the conducting element (e.g. away from the substrate on which the conducting elements are formed). The conducting elements may have a substantially constant width along their length or the width of the conducting elements may vary along their length.

In some embodiments, the conducting elements (e.g. copper tracks or tubes) have a substantially constant width along their length of between 1 mm and 20 mm, e.g. between 5 mm and 15 mm, e.g. between 5 mm and 10 mm. In one embodiment the conducting elements comprise copper tracks having a (e.g. constant) width of approximately 10 mm and a (e.g. constant) thickness of approximately 70 µm. In another embodiment, the conducting elements comprise cylindrical tubes with a circular cross-section having a (e.g. constant) 1 mm wall thickness and (e.g. constant) 10 mm width along their length.

In some embodiments, the conducting elements have a varying width (e.g. at least one thicker portion and at least one thinner portion) along their length, e.g. a tapered design. Preferably the thinner portion of the conducting element is arranged to be at (e.g. each of) the positions of overlap of a pair of crossing conducting elements (e.g. each extending along a path) in the continuous conducting path.

In embodiments comprising conducting elements comprising a taper, the width of the thinner portion is less than the width of the thicker portion, e.g. the width of the thinner portion is between 10% - 90% of the width of the thicker portion width, e.g. the thinner portion is between 30% - 70% of the width of the thicker portion width, e.g. the thinner portion is approximately 50% of the width of the thicker portion.

In one embodiment, where the conducting elements comprise copper tracks having a taper, the at least one thicker portion of the conducting element has a width of approximately 10 mm and a thickness of approximately 70 µm and the at least one thinner portion of the conducting element has a width of approximately 5 mm and a thickness of approximately 70 µm.

It will be appreciated that the transition between the at least one thicker portion of the conducting element and the at least one thinner portion of the conducting element may be arranged in any suitable and desirable configuration. For example, in some embodiments the transition between the thicker portion and the thinner portion may be through a discontinuous step change in the thickness. In other embodiments the transition between the thicker portion and the thinner portion may be a continuous linear gradient (e.g. a slope) or a curve (e.g. a sigmoid curve). It will be appreciated that a curved transition between the thicker portion and thinner portion will help to reduce localised electric fields or electric field "hot spots" at the points of conductor thickness transition. It will be appreciated that these transitions provide improvement to the electrodynamic properties of the coil, e.g. reducing peak electric field strength.

It will be appreciated that the (e.g. at least one) thinner portion of the conducting element may be any suitable and desirable length extending across (e.g. at least one) crossing point between a pair of crossing conducting elements. In some embodiments having a plurality (e.g. two) crossing points that are within close proximity, the thinner portion of the conducting element may extend across both crossing points without a transition back to the thicker portion of the conducting element.

Embodiments with conducting elements having a variation in width along their length help to reduce the radiofrequency coil resistance by providing a reduced overlap area between pairs of conducting elements (e.g. conducting element pairs in adjacent parallel layers). The reduction in resistance results from proximity effects between two close conductors (and thus helps to maintain the homogeneity and strength of the generated magnetic field). Reducing the radiofrequency coil resistance thus provides increased coil sensitivity and an increased signal-to-noise ratio (SNR) resulting in an improved receive performance when the radiofrequency coil is configured to receive.

The plurality of conducting elements may be arranged in any suitable and desired way to form the continuous conducting path of the radiofrequency coil. In one embodiment the plurality of conducting elements are arranged about a common central region of the radiofrequency coil. Thus, preferably the plurality of conducting elements (e.g. together completely) surround the common central region. Preferably the common central region is free from conducting elements, e.g. the conducting elements (and thus the continuous conducting path) are arranged substantially in (and, e.g., confined to) an annulus surrounding the common central region.

Preferably the radiofrequency coil comprises a central axis that extends substantially perpendicularly to the substantially parallel surfaces in which the conducting elements lie. Preferably the central axis extends through the common central region. For example, preferably the common central region comprises a common central area that is substantially parallel to the substantially parallel surfaces of the conducting elements and preferably the central axis extends substantially perpendicularly to the common central area. In one set of embodiments, the radiofrequency coil may be arranged such that the target sample (e.g. organ) of interest lies (at some depth) along the central axis. As has been explained, the homogeneity and sensitivity of the oscillating magnetic field transmitted and received (e.g. about the central axis) by the radiofrequency coil according to at least preferred embodiments of the present invention may be enhanced compared to conventional designs.

The radiofrequency coil may have any suitable and desired number of conducting elements. Preferably the radiofrequency coil comprises at least three conducting elements, e.g. at least four conducting elements, e.g. at least six conducting elements, although it will be appreciated that a greater number of conducting elements helps to increase the total magnetic flux density generated by the radiofrequency coil for transmitting into the sample and/or the ability of the radiofrequency coil to receive and detect an oscillating magnetic field emitted by the sample.

The plurality of conducting elements may be any suitable and desired shape. The plurality of conducting elements may all comprise the same shape; alternatively, the plurality of conducting elements may comprise two or more different shapes. Preferably at least some (e.g. each) of the plurality of conducting elements comprises a smooth shape. This helps to avoid concentrations in the local electric field, thus reducing the amount of localised heating occurring within the sample.

Preferably at least some (e.g. each) of the plurality of conducting elements comprises an open shape, i.e. such that a conducting element having this shape does not fully enclose the area it defines. For example, at least some (e.g. each) of the plurality of conducting elements comprises an arc of a circle, preferably subtending at least 180°, e.g. at least 270°. In another example, one or more of the plurality of conducting elements comprises two sides of a triangle having a rounded apex.

In another example, one or more of the plurality of conducting elements comprises an omega (Ω) shape, e.g. having rounded corners. The "tails" of the omega shape help to provide transmission and/or reception gains outside of the area bounded by the conducting element.

In a preferred embodiment the plurality of conducting elements are arranged in a rotationally symmetric configuration, e.g. preferably the continuous conducting path is rotationally symmetric. In a preferred embodiment, the plurality of conducting elements are arranged such that a (e.g. each) conducting element of the plurality of conducting elements is positioned at a rotated position relative to another of the plurality of conducting elements. Thus, preferably the shape of the conducting elements is chosen such that they tessellate rotationally with respect to adjacent conducting elements when arranged into the continuous conducting path.

Preferably the order of rotational symmetry (e.g. of the plurality of conducting elements and thus, for example, the continuous conducting path) is greater than or equal to (e.g. two times) the number of conducting elements that form the continuous conducting path. This helps to increase the number of conducting elements that are able to be accommodated in the continuous conducting path, e.g. without any overlapping conducting elements. Preferably, for reasons discussed further below, the continuous conducting path comprises no conducting elements that (e.g. completely) overlap with (e.g. follow substantially the same path as) others of the conducting elements. This helps to reduce the resistance of the coil from proximity effects.

In a preferred embodiment, the plurality of conducting elements are arranged about an axis of rotation that coincides with the geometric centre of the continuous conducting path. Preferably the geometric centre of the continuous conducting path and/or the axis of rotation of the plurality of conducting elements is offset from the geometric centre of one or more (e.g. each) of the plurality of conducting elements. Offsetting a conducting element from the centre of the continuous conducting path, but e.g., in a configuration in which the continuous conducting path as a whole is rotationally symmetric, helps to minimise the coupling of current paths in the radiofrequency coil.

Preferably a (e.g. each) conducting element of the plurality of conducting elements is rotated with respect to another of the plurality of conducting elements (preferably in an adjacent substantially parallel surface) through an angle of 360/N degrees, where N is the rotational symmetry of the continuous conducting path. Thus N may be less than (e.g. half) or equal to the total number of conducting elements forming the continuous conducting path.

Preferably the plurality of conducting elements are arranged such that an end (or both ends) of a (e.g. each) conducting element is connected to another of the conducting elements (preferably in an adjacent substantially parallel surface) so as to form the continuous conducting path. Thus, preferably the conducting elements are rotated with respect to each other such that the ends connect to each other to form the continuous conducting path. Preferably, the points at which pairs of ends of the conducting elements connect to each other are spaced from each other by an angle of 360/N degrees (e.g. about the geometrical centre and/or rotational centre of the continuous conducting path), where N is the number of conducting elements forming the continuous conducting path.

Each conducting element defines an area bounded by the conducting element. The (e.g. each) conducting element at least partially (but, e.g., not fully) surrounds the area it bounds and the remainder of the area defined by the (e.g. each) conducting element is bounded by a geodesic line (e.g. a straight line) extending between the ends of the conducting element. Thus, preferably a (e.g. each) conducting element forms (at least part, e.g. majority, of) the perimeter of the bounded area.

The conducting elements may be connected to each other in any suitable and desired way to form the continuous conducting path. Preferably a (e.g. each) conducting element is connected to another of the conducting elements in an adjacent substantially parallel surface so as to form the continuous conducting path. Preferably a (e.g. each) conducting element is connected to another of the conducting elements at a periphery of the continuous conducting path.

The Applicant has appreciated that linking together conducting elements which, for example, are overlapping but offset from each other, may cause small current loops to be generated, e.g. at the periphery of the continuous conducting path. When the continuous conducting path has a shape (formed by the shape and relative positioning of the conducting elements) that comprises peripheral loops, preferably the rotational direction of the current path in the peripheral loops is opposite to the rotational direction of the current path in the rest of the continuous conducting path. This arrangement means that the magnetic field generated by the peripheral loops adds in phase, helping to avoid a null point in the magnetic field. Over the whole of the continuous conducting path, this helps to improve the homogeneity and magnetic flux density, as well as the spatial coverage, of the magnetic field generated by the radiofrequency coil.

The conducting elements of the continuous conducting path may be connected to each other in any suitable and desired way. Preferably a (e.g. each) conducting element is connected to another of the conducting elements by one or more discrete electrical components or by through-layer electrical connections (known as vias). The one or more discrete electrical components (e.g. which connect conducting elements on adjacent substantially parallel surfaces) preferably comprise one or more capacitors and/or one or more LC traps. Providing a discrete electrical component (e.g. including a capacitance) helps to bridge between and thus connect the conducting elements in the different substantially parallel surfaces. It may also break up the inductance which helps to reduce any loops of pure inductance. Preferably the ends of the conducting elements are spaced from each other, e.g. to allow room to locate the discrete electrical component(s).

It will be appreciated, that (as is the case in at least preferred embodiments) positioning such component(s) at the outer region of the continuous conducting path helps to reduce any disturbance of the magnetic field at the central region of the radiofrequency coil (which is preferably desired to be substantially homogeneous) which may be caused by local distortions in the magnetic field from these components.

In one embodiment (e.g. in addition to or instead of discrete electrical component(s) (e.g. capacitor(s)) between the conducting elements) a (e.g. each) conducting element comprises one or more discrete electrical components (e.g. capacitors) arranged part way along the length of the conducting element. This helps to distribute the, e.g., capacitance along the length of the continuous conducting path, which helps to reduce the electric field (and thus the heat) generated. The distributed capacitance also helps to reduce phase variations of the alternating current along the continuous conducting path, which helps to generate a larger and more homogeneous magnetic field. The conducting elements may (e.g. each) have any suitable number of capacitors distributed along their length, e.g. one or two per conducting element (but this could be more or fewer).

As indicated above, preferably the conducting elements and/or the continuous conducting path are arranged on a substrate. Preferably the substrate comprises a printed circuit board or components involved in the manufacture thereof. Preferably each of the conducting elements is arranged on a respective substrate which, e.g., are then arranged into the substantially parallel surfaces to form the continuous conducting path. In one embodiment the continuous conducting path (e.g. formed by the conducting elements each arranged on individual substrates) is mounted on a mounting substrate, e.g. made of glass reinforced plastic, e.g. FR-4.

The radiofrequency coil could be flexible or rigid. Thus, the substrate (e.g. on which the conducting elements are formed and/or the mounting substrate on which the continuous conducting path is mounted) may be rigid or flexible. Providing a flexible radiofrequency coil may allow the coil to be shaped to fit around the particular sample (e.g. body part) being scanned, e.g. to improve the penetration of the magnetic field into the sample. When the radiofrequency coil is flexible, preferably one or more of the capacitor(s) between or along the length of the conducting elements may be variable. This helps to compensate for changes in the inductance (and thus resonant frequency) of the radiofrequency coil when its shape is changed.

The radiofrequency coil may comprise a protective coating, e.g. be covered in a foam or plastic layer. The protective coating may be rigid or flexible, e.g. depending on the desired application for the radiofrequency coil. Providing a protective coating may allow the radiofrequency to be cleaned more easily, e.g. when it is used for applications in which hygiene is important.

A (e.g. each) conducting element in its substantially parallel surface is separated from the conducting element in the adjacent substantially parallel surface by a (e.g. layer of) dielectric. Thus, preferably the plurality of conducting elements in their respective substantially parallel surfaces are interleaved by one or more layers of dielectric (preferably a layer of dielectric between each adjacent substantially parallel surfaces).

The dielectric may be arranged in any suitable and desired way. Preferably the dielectric is arranged (e.g. at least) between the locations where pairs of conducting elements in the (e.g. adjacent) substantially parallel surfaces cross over each other. Providing a dielectric at the region of overlap between the conducting elements helps to prevent electrical connections between conducting elements in adjacent substantially parallel surfaces.

While a (e.g. each) dielectric may extend over all of the area over which the conducting elements in adjacent substantially parallel surfaces extend, a (e.g. each) dielectric may not extend to the part of the conducting elements in adjacent substantially parallel surfaces that are connected to each other, e.g. such that the conducting elements are connected to each other radially outward of the dielectric. Preferably, the (e.g. each) dielectric comprises one or more apertures (e.g. at the periphery of the continuous conducting path) through which pairs of the conducting elements are connected to each other, to form the continuous conducting path. Thus, preferably the (e.g. each layer of) dielectric extends over substantially all of the pair of conducting elements it is arranged between, e.g. apart from where the connection between the (e.g. each) pair of conducting elements is made. This helps to support the conducting elements and prevent electrical connections between conducting elements in adjacent substantially parallel surfaces (e.g. apart from the ends of the conducting elements where a connection is desired to be made). Preferably the dielectric (layers) does not extend over at least part of the common central region of the radiofrequency coil (e.g. the region surrounding the central axis of the radiofrequency coil).

The (e.g. layer(s) of) dielectric may be any suitable and desired type of dielectric. In one embodiment the dielectric comprises a polyimide material (e.g. Kapton). In one embodiment the dielectric comprises polytetrafluoroethylene (PTFE). Preferably the dielectric has a thickness between 1 µm and 10 mm, e.g. between 10 µm and 1 mm, e.g. between 30 µm and 70 µm, e.g. approximately 50 µm. The type of material and/or the thickness of the dielectric may be chosen to control the coupling between the conducting elements. For example, the lower bound thickness may be determined by the dielectric properties of the material, in particular its dielectric strength, and the maximum RF power produced by a given RF transmitter.

The substantially parallel surfaces in which the conducting elements are arranged could be planar or non-planar (e.g. curved). Thus, the radiofrequency coil (and the continuous conducting path) may be planar or non-planar (e.g. curved). Providing a non-planar (e.g. curved) radiofrequency coil helps to place the effective centre of the radiofrequency coil (for the purposes of the magnetic field being generated) closer to the part of the sample (e.g. organ of the patient) that is to be scanned.

When the radiofrequency coil is curved, preferably the radiofrequency coil comprises (and thus the continuous conducting path is formed on) part of the surface of a cylinder. The cross-sectional shape of the cylinder preferably comprises a smooth curved shape but one that is not necessarily circular, e.g. a parabola or an ellipse. Preferably the continuous conducting path is arranged such that the central axis of the radiofrequency coil is substantially perpendicular to the main axis of the cylinder.

The area bounded by each conducting element overlaps with at least 20% of the area bounded by the conducting element in an another, e.g. adjacent, substantially parallel surface. The conducting elements in adjacent substantially parallel surfaces may be arranged in any suitable and desired way to achieve this, e.g. using the rotationally symmetric configurations discussed above. In some embodiments the area bounded by each conducting element overlaps with at least 30% of the area bounded by the conducting element in an adjacent substantially parallel surface, e.g. with at least 40%, e.g. with at least 50%, e.g. with at least 60%, e.g. with at least 70%, e.g. with at least 80%, e.g. with at least 90%.

As well as the area of conducting elements in adjacent substantially parallel surfaces overlapping, preferably the bounded areas of three or more (e.g. all) of the conducting elements overlap with each other, e.g. at the central axis of the radiofrequency coil. The three or more overlapping bounded areas of the conducting elements may overlap (e.g. have a common overlapping area) by any suitable and desired amount (in addition to them overlapping by at least 20% of the area of the conducting element in an adjacent substantially parallel surface). In one embodiment the plurality of conducting elements are arranged such that the common area of overlap for the areas bounded by three or more (e.g. all) of the plurality of conducting elements is at least 10% of a total area over which the areas bounded by the three or more (e.g. all) conducting elements extend, e.g. at least 15%, e.g. at least 20%, e.g. at least 30%, e.g. at least 40 %, e.g. at least 50%.

The plurality of conducting elements may also be arranged such that the area covered only by one of the plurality of conducting elements (i.e. the area bounded by the continuous conducting path over which there is no overlap of the bounded areas of the conducting elements) is reduced. Thus, in one embodiment, the plurality of conducting elements are arranged such that less than 40% (e.g. less than 30%, e.g. less than 10%) of the total area enclosed by the continuous conducting path does not have an overlap of at least some of the bounded areas defined by the plurality of conducting elements. (In other words, the area enclosed by the continuous conducting path over which is covered by the areas of only one of the plurality of conducting elements at a time is less than 40% (e.g. less than 30%, e.g. less than 10%) of the total area enclosed by the continuous conducting path.)

In at least some embodiments, as well as the conducting elements being arranged with respect to each other in order to increase the overlap between them (e.g. in order to increase the overlap of the magnetic flux density generated), preferably the conducting elements are arranged such that they reduce the overlap of current paths, e.g. in the same direction. This helps to reduce the resistances as a result of proximity effects between two close conductors (which thus helps to maintain the homogeneity and strength of the generated magnetic field). Thus, preferably at (e.g. each of) the overlap of a pair of crossing conducting elements (e.g. each extending along a path) in the continuous conducting path, the conducting elements cross with an angle that is greater than 20°, e.g. greater than 30°, e.g. greater than 40°. Providing a lower bound on the crossing angle between conducting elements helps to reduce the overlap of current paths in the radiofrequency coil.

The radiofrequency coil, the continuous conducting path and the conducting elements may have any suitable and desired size. In one embodiment (e.g. for human application) the effective diameter of the radiofrequency coil (that is the diameter of a single loop circular radiofrequency coil with the most comparable magnetic field profile) is between 100 mm and 300 mm, e.g. between 120 mm and 160 mm, e.g. approximately 140 mm, e.g. approximately 150 mm.

The radiofrequency coil may be used in an MRI system (e.g. scanner) in any suitable and desired way. In one embodiment, the radiofrequency coil is arranged to operate as a single coil. In one embodiment the radiofrequency coil is arranged to operate in combination with other coils. For example, two radiofrequency coils may be arranged to be operated in a quadrature configuration, or additionally an array of radiofrequency coils may be arranged to be operated in combination (e.g. in an "array" configuration).

Thus, preferably the invention extends to a plurality of radiofrequency coils (as outlined according to the first aspect of the invention) arranged to operate in combination with each other.

A plurality of radiofrequency coils may be arranged in an array in any suitable or desirable geometrical configuration. It will be appreciated that the arrangement of radiofrequency coils in an array may be in any suitable or desirable pattern, e.g. linear, honeycomb, triangular (e.g. equilateral or isosceles), circular or diamond.

In an embodiment, three radiofrequency coils are overlapped, e.g. in a (e.g. isosceles) triangle arrangement, wherein each of the radiofrequency coils preferably overlaps (e.g. geometrically and/or inductively (when operated, in use)) with both of the other two coils (e.g. three overlapped radiofrequency coils, wherein each of the three coils is overlapped with each of the other coils). In another embodiment, three radiofrequency coils are overlapped in a linear arrangement, wherein the central radiofrequency coils preferably overlaps (e.g. geometrically and/or inductively (when operated, in use)) with each of the other two coils (e.g. two pairs of overlapped radiofrequency coils). Any number of radiofrequency coils may be overlapped in any suitable and desired, e.g. interlocking or linear, pattern.

In some embodiments, one or more (e.g. all) of the radiofrequency coils of a plurality of radiofrequency coils in an array may be spatially separated from each other (e.g. there is no overlap in the area of a pair of (e.g. any) two radiofrequency coils (e.g. as defined by their conducting elements) in the array). In other embodiments, one or more (e.g. adjacent) radiofrequency coils in a plurality of radiofrequency coils may (e.g. each) be spatially overlapped (e.g. geometrically overlapped) with one or more other radiofrequency coils in the plurality of radiofrequency coils, e.g. as defined by their conducting elements.

Thus pairs of (e.g. adjacent) radiofrequency coils (of the plurality of radiofrequency coils) may be overlapped with each other. Any particular radiofrequency coil of the plurality of radiofrequency coils may overlap with any number (e.g. one, two or more) of other coils of the plurality of radiofrequency coils, thus forming multiple different pairs of coils.

In embodiments where radiofrequency coils are overlapped (e.g. geometrically), the centre-to-centre coil distance (e.g. the distance between the centre of a first radiofrequency coil to the centre of a second radiofrequency coil) of (e.g. each of) one or more pairs of radiofrequency coils is between 33% and 100% of the size of the (e.g. effective) radiofrequency coil diameter, e.g. between 50% and 75%. When the centre-to-centre distance exceeds 100% of the (e.g. effective) radiofrequency coil diameter, the radiofrequency coils are not overlapped (e.g. are spatially separated).

Preferably, radiofrequency coils are inductively overlapped to help isolate or decouple the electromagnetic fields generated in one radiofrequency coil from neighbouring radiofrequency coil(s) and to reduce the mutual inductance between the pairs of radiofrequency coils. Overlapping radiofrequency coils in a receive array (e.g. an array comprising a plurality of radiofrequency coils configured to receive) thus helps to provide a receive array which can receive signal from wider regions of the body (e.g. the area covered by the radiofrequency coil array) whilst retaining the increased sensitivity and increased signal-to-noise ratio of each individual radiofrequency coil. It will be appreciated that rotation of one radiofrequency coil (of a pair of radiofrequency coils) about its central axis (of the individual coil) may help to fine tune the decoupling between pairs of overlapped radiofrequency coils.

Preferably, the centre-to-centre distance of two overlapping radiofrequency coils is chosen to be that at which the smallest mutual inductance is provided, e.g. the point of greatest decoupling between two radiofrequency coils. It will be appreciated that the distance that corresponds to the optimised decoupling geometry may be determined in any suitable or desirable way. For example, the position of minimum transmission may be measured experimentally using a Vector Network Analyser. Alternatively, it may be simulated computationally by determining the smallest Sₙₘ transmission parameter, where Sₙₘ measures the transmission between a first coil *n* and a second coil m.

Embodiments of the invention will now be described, by way of example only, with reference to the accompanying drawings, in which:
Figures 1a and 1b show a radiofrequency coil in accordance with an embodiment of the present invention;
Figures 2a and 2b show another radiofrequency coil in accordance with an embodiment of the present invention;
Figures 3a, 3b and 3c show another radiofrequency coil in accordance with an embodiment of the present invention;
Figure 4 shows a circuit diagram for how a radiofrequency coil in accordance with an embodiment of the present invention may be used.
Figure 5 shows another radiofrequency coil in accordance with an embodiment of the present invention;
Figure 6 shows another radiofrequency coil in accordance with an embodiment of the present
Figures 7a and 7b show another radiofrequency coil in accordance with an embodiment of the present invention;
Figures 8a to 8d show simulated surface and cross-section oscillating radiofrequency magnetic (B,+) fields for two radiofrequency coils in accordance with embodiments of the present invention;
Figures 9a to 9d shows the on-axis simulated oscillating radiofrequency magnetic (B₁+) fields and simulated signal-to-noise ratio results of Figure 8 through the centre of the radiofrequency coil;
Figures 10a to 10d show simulated surface and cross-section oscillating radiofrequency magnetic (B,+) fields for two overlapping radiofrequency coils in accordance with an embodiment of the present invention; and
Figures 11a to 11f show simulated surface and cross-section oscillating radiofrequency magnetic (B,+) fields for three overlapping radiofrequency coils in accordance with an embodiment of the present invention; and
Figures 12a to 12c shows the simulated S₂₁ parameter values as the overlap of a two radiofrequency surface coil system, in accordance with an embodiment of the present invention, is varied.

Magnetic resonance imaging (MRI) scanners are used to perform magnetic resonance measurements of a sample, for example magnetic resonance imaging or spectroscopy of a human or animal subject, typically to investigate the anatomy and physiology of the subject, e.g. to detect pathologies or abnormalities. MRI scanners include a large primary magnet that applies a static magnetic field over the scanning volume to polarise the nuclear spins of the sample being scanned, a gradient magnet that applies a magnetic field having a linear variation across the scanning volume to allow spatial localisation, and a radio frequency (RF) system to transmit an oscillating magnetic field (to excite nuclei in the sample) and receive RF radiation (from the subsequent relaxation of the excited nuclei).

Embodiments of the present invention will now be described that provide the RF system in the form of a radiofrequency coil which both transmits and receives the (RF) oscillating magnetic field (it will be appreciated that these radiofrequency coils may be used only to transmit or only to receive an oscillating magnetic field).

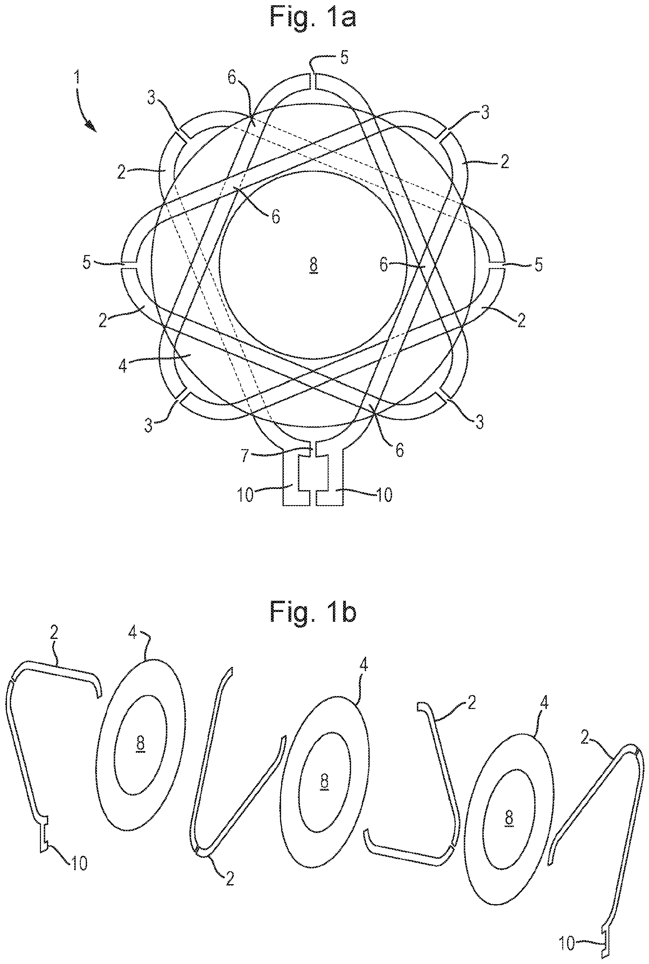

Figures 1a and 1b show a radiofrequency coil 1 in accordance with an embodiment of the present invention. Figure 1a shows the assembled radiofrequency coil 1 and Figure 1b shows an exploded view of the different components (layers) of the radiofrequency coil 1.

As can be seen from Figures 1a and 1b, the radiofrequency coil 1 is formed from four conducting elements 2 that each have a triangular shape with rounded corners. The conducting elements 2 are each formed from a 10 mm wide track of copper which is deposited onto a printed circuit board. A bridging capacitor is positioned at the midpoint 3 of each of the conducting elements 2.

The four conducting elements 2 are connected together (using discrete electrical components at the gaps 5 between the conducting elements 2) to form a continuous conducting path that forms the radiofrequency coil 1. Each conducting element 2 is positioned at a rotation of the conducting elements 2 to which it is connected, such that the continuous conducting path is rotationally symmetric. The conducting elements 2 are each separated by an annular shaped dielectric layer 4 (in the form of a polyimide sheet). The formed radiofrequency coil 1 is mounted on a FR-4 substrate.

The dielectric layers 4 and conducting elements 2 are arranged on top of each other such that a dielectric layer 4 is provided between the conducting elements 2 at all of the crossing points 6 of the conducting elements 2. An aperture 8 is provided in the dielectric layers 4 in the centre of the radiofrequency coil 1. The ends of each conducting element 2 (and thus the connections between the conducting elements 2) extend radially outward of the dielectric layers 4, such that they can be connected together.

Two of the conducting elements 2 include contacts 10 at their ends to allow electrical contact to be made, in order to supply an oscillating current to the continuous conducting path of the radiofrequency coil 1 to transmit an oscillating magnetic field into the sample to be scanned and/or to receive an oscillating magnetic field that is emitted from the sample being scanned. The contacts 10 provide a gap 7 for one or more "matching" capacitors to impedance transform between the transmit and/or receive chain and the radiofrequency coil 1.

In operation, the radiofrequency coil 1 is placed over the part of the sample to be scanned. The sample and the radiofrequency coil 1 are inserted together into the bore of an MRI scanner. The primary and gradient magnets of the MRI scanner are operated to apply their respective magnetic fields over the volume of the scanner and the radiofrequency coil 1 is driven (through its contacts 10) by an oscillating current to generate and transmit an oscillating magnetic field into the sample to be scanned (i.e. the part of the sample over which the radiofrequency coil 1 has been placed).

The transmitted oscillating magnetic field acts to excite the (target species of) nuclei in the sample that have been polarised by the primary magnetic field. These excited nuclei then relax and emit an RF oscillating magnetic field which is then received and detected by the radiofrequency coil 1. Processing the detected oscillating magnetic field allows the position of the (target species of) nuclei in the sample to be scanned.

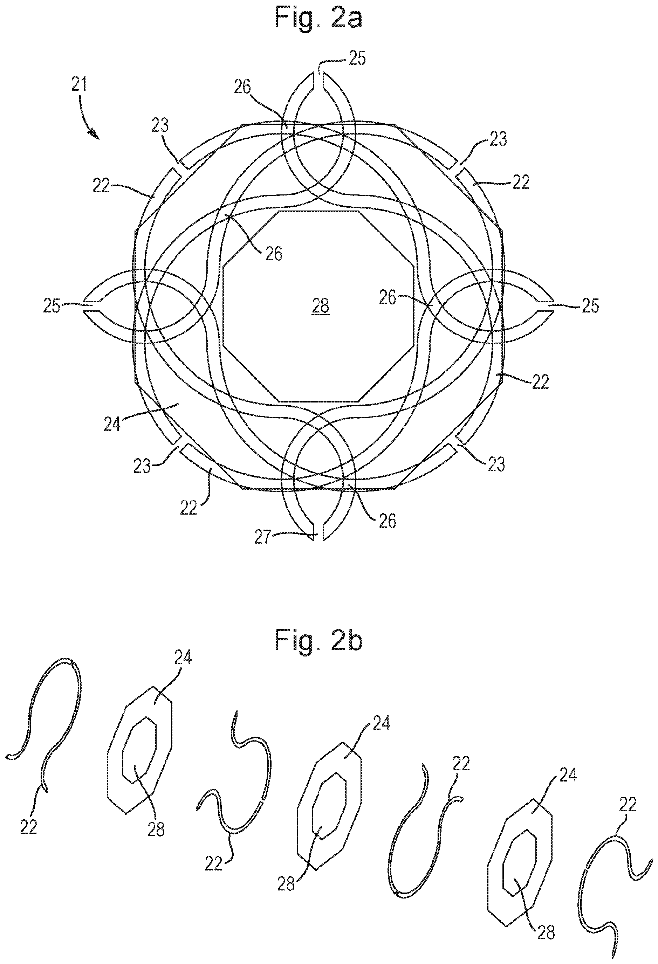

Figures 2a and 2b show another radiofrequency coil 21 in accordance with an embodiment of the present invention. The radiofrequency coil 21 shown in Figures 2a and 2b is similar to the radiofrequency coil 1 shown in Figures 1a and 1b in that it has four conducting elements 22 that have discrete electrical components (e.g. bridging capacitors) arranged at their midpoints 23 and are connected together (using discrete electrical components at the gaps 25 between the conducting elements 22 and a matching capacitor at the gap 27 where contacts to connect to an oscillating current supply are provided) to form a continuous conducting path, with the conducting elements 22 arranged in a rotationally symmetric configuration. Similarly, the conducting elements 22 are separated by respective dielectric layers 24.

The difference in the radiofrequency coil 21 shown in Figures 2a and 2b is in the shape of the conducting elements 22 and the dielectric layers 24. In Figures 2a and 2b the radiofrequency coil 21 is constructed from conducting elements 22 each having an "omega (Ω)" shape and the dielectric layers 24 are an octagonal annulus having a central aperture 28 (but again arranged such that the dielectric layers 24 are positioned between crossing points 26 of the conducting elements 22).

Operation of the radiofrequency coil 21 shown in Figures 2a and 2b is very similar to the operation of the radiofrequency coil 1 shown in Figures 1a and 1b. The different shape of the continuous conducting path of the radiofrequency coil 21 of Figures 2a and 2b will generate an oscillating magnetic field having a different shape to that generated by the radiofrequency coil 1 shown in Figures 1a and 1b, but will otherwise operate in a very similar manner.

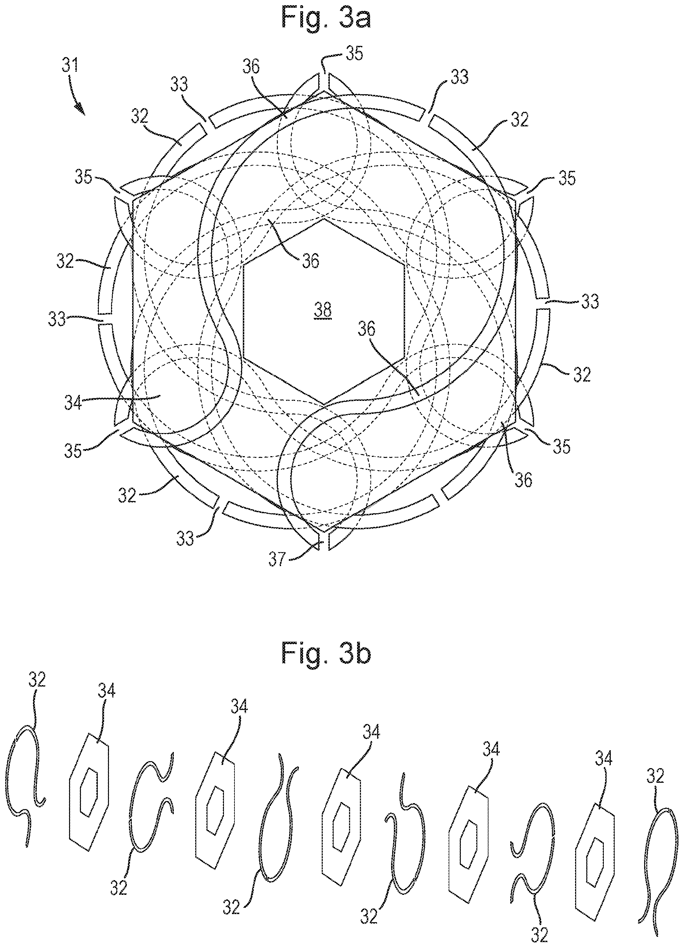

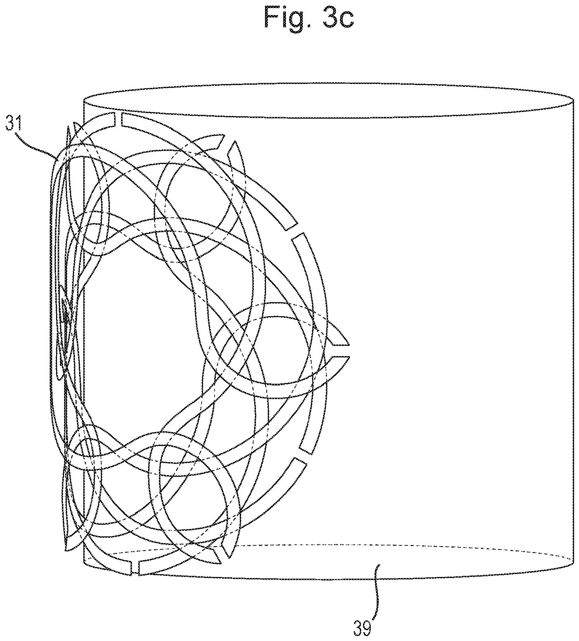

Figures 3a, 3b and 3c show another radiofrequency coil 31 in accordance with another embodiment of the present invention. The radiofrequency coil 31 shown in Figures 3a, 3b and 3c is similar to the radiofrequency coil 21 shown in Figures 2a and 2b in that it has "omega (Ω)" shaped conducting elements 32 that have discrete electrical components (e.g. bridging capacitors) arranged at their midpoints 33 and are connected together (using discrete electrical components at the gaps 35 between the conducting elements 32 and a matching capacitor at the gap 37 where contacts to connect to an oscillating current supply are provided) to form a continuous conducting path, with the conducting elements 32 arranged in a rotationally symmetric configuration. Similarly, the conducting elements 32 are separated by respective dielectric layers 34.

The difference in the radiofrequency coil 31 shown in Figures 3a, 3b and 3c is in the number and rotational symmetry of the conducting elements 32. In Figures 3a, 3b and 3c the radiofrequency coil 31 is constructed from six conducting elements 32, such that the continuous conducting path has six-fold rotational symmetry (compared to the four-fold symmetry of the radiofrequency coil 21 in Figures 2a and 2b). The dielectric layers 34 of the radiofrequency coil 31 shown in Figures 3a, 3b and 3c are a hexagonal annulus having a central aperture 38 (but again arranged such that the dielectric layers 34 are positioned between crossing points 36 of the conducting elements 32).

As can be seen from Figure 3c, the radiofrequency coil 31 is curved around the surface of a cylinder 39 (e.g. the radiofrequency coil 31 may be mounted on a portion of a cylindrical sheet of glass reinforced plastic). This helps to conform the radiofrequency coil 31 to the part of the sample to be scanned, which moves the effective centre of the radiofrequency coil 31 closer to the internal part of the sample to be scanned.

Operation of the radiofrequency coil 31 shown in Figures 3a, 3b and 3c is very similar to the operation of the radiofrequency coils 1, 21 shown in Figures 1a and 1b and Figures 2a and 2b. The different number of conducting elements 32 and thus the different shape of the continuous conducting path of the radiofrequency coil 31 of Figures 3a, 3b and 3c will generate an oscillating magnetic field having a different shape to that generated by the radiofrequency coils 1, 21 shown in Figures 1a and 1b and Figures 2a and 2b, but will otherwise operate in a very similar manner.

One of the main operational differences of the radiofrequency coil 31 shown in Figures 3a, 3b and 3c is owing to its curved shape. As indicated above, the curved shape of the radiofrequency coil moves the effective centre of the radiofrequency coil 31 closer to the internal part of the sample to be scanned. This helps the generated and transmitted oscillating magnetic field to penetrate deeper into the part of the sample to be scanned, and helps the radiofrequency coil 31 to receive and detect the emitted oscillating magnetic field from a deeper penetration.

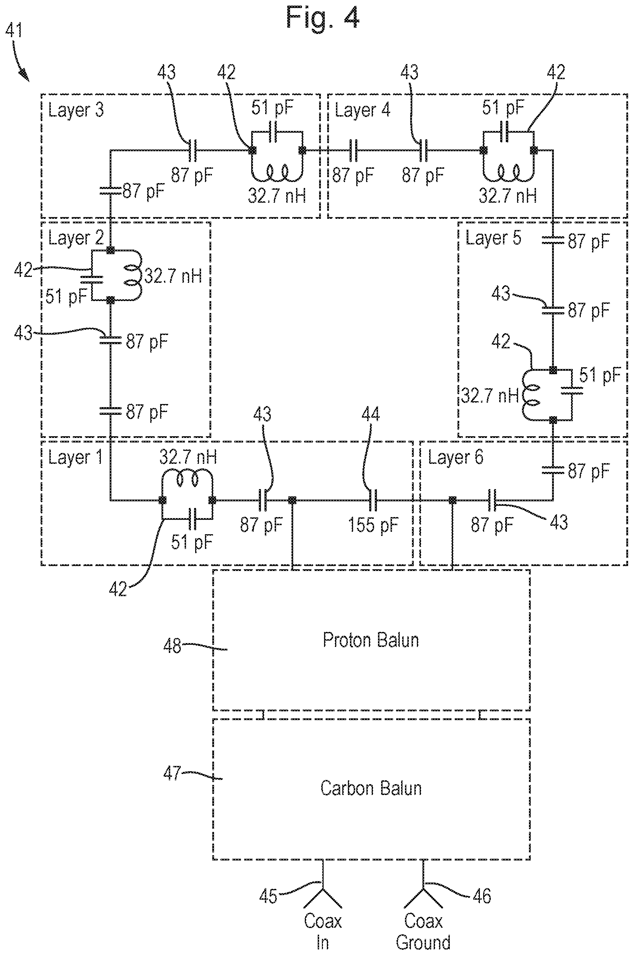

Figure 4 shows a circuit diagram according to an embodiment of the present invention that may be used with and to operate the radiofrequency coil 31 shown in Figures 3a, 3b and 3c (a similar circuit may be used with the radiofrequency coils 1, 21 shown in Figures 1a and 1b, and Figures 2a and 2b, e.g. with the appropriate number of sets of discrete electrical components).

The circuit 41 shown in Figure 4 includes a set of discrete electrical components for each "layer" (for or between each of the conducting elements) of the radiofrequency coil. In each layer this includes an LC trap 42 (a 51 pF capacitor in parallel with a 32.7 nH inductor, both of which are in series with a 87 pF capacitor in the adjacent layer) and a 87 pF bridging capacitor 43. The LC traps 42 are, for example, arranged at the gaps 35 between the conducting elements 32 of the radiofrequency coil 31 shown in Figures 3a, 3b and 3c. The bridging capacitors 43 are, for example, arranged at the midpoints 33 of the conducting elements 32.

The circuit 41 also includes a 155 pF matching capacitor 44 arranged between the ends of the continuous conducting path, between the external contacts of the radiofrequency coil. The matching capacitor 44 is, for example, arranged at the gap 37 in the radiofrequency coil 31 shown in Figures 3a, 3b and 3c, between the contacts for the external oscillating current supply to be provided. The circuit 41 includes a coaxial input line 45 and a coaxial ground line 46 which are connected into the continuous conducting path of the circuit via a carbon balun 47 and a proton balun 48.

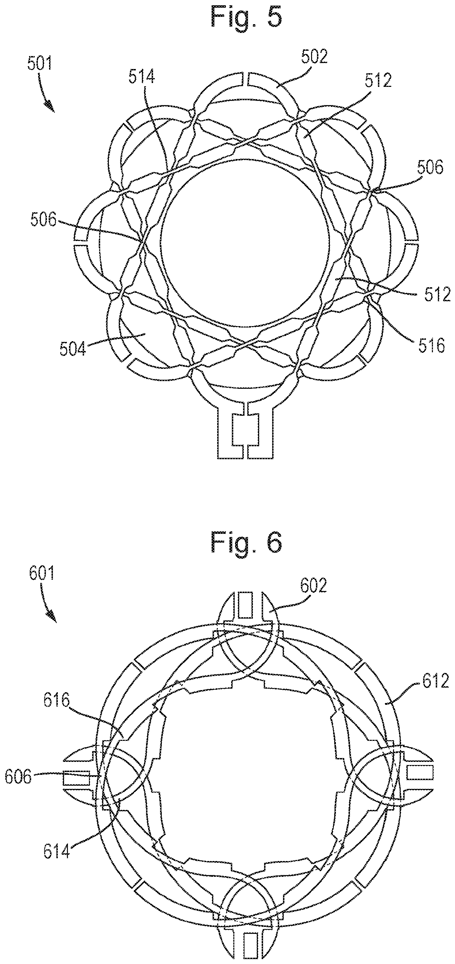

Figure 5 shows another radiofrequency coil 501 in an assembled configuration in accordance with an embodiment of the present invention. The shape of the radiofrequency coil conducting elements 502 are similar to the radiofrequency coil 1 shown in Figures 1a and 1b in that it has four conducting elements 502 that each have a triangular shape with rounded corners. The difference in the radiofrequency coil 501 shown in Figure 5 is that the conducting elements have a varying width along their length, e.g. a tapered design, comprising multiple thicker portions 512 and multiple thinner portions 514. The thinner portions 514 of the conducting element 502 are positioned at crossing points 506 between conducting elements 502 arranged on top of each other and separated by a dielectric layer 504. The transition 516 between the thicker portions of the conducting elements and the thinner portions of the conducting elements is shown to be a continuous gradient, e.g. a slope design.

Operation of the radiofrequency coil 501 shown in Figure 5 is very similar to the operation of the radiofrequency coil 1 shown in Figures 1a and 1b. The varying thickness of the continuous conducting path of the radiofrequency coil 501 of Figure 5 will generate an oscillating magnetic field having a different shape and/or magnitude to that generated by the radiofrequency coil 1 shown in Figures 1a and 1b, but will otherwise operate in a very similar manner.

Figure 6 shows another radiofrequency coil 601 in accordance with an embodiment of the present invention. The radiofrequency coil 601 is similar to the radiofrequency coil 2 shown in Figure 2 in that each have four conducting elements with an "omega (Ω)" shape. The difference in the radiofrequency coil 601 is that the conducting elements vary in width along their length, e.g. they have a tapered design.

As with the radiofrequency coil 501 shown in Figure 5, the conducting elements 602 have multiple thicker portions 612 and thinner portions 614 where the thinner portions are positioned at crossing points 606 between conducting elements 602 arranged on top of each other. Unlike the radiofrequency coil 501 shown in Figure 5, radiofrequency coil 601 has thinner portions 614 which extend across multiple crossing points 606. The thicker portions have a width of 10 mm. The thinner portions have a width of 5 mm. The transition 616 between the thicker portions 612 of the conducting elements and the thinner portions 614 of the conducting elements 802 is shown to have a slope design.

Operation of the radiofrequency coil 601 shown in Figure 6 is very similar to the operation of the radiofrequency coil 1 shown in Figures 1a and 1b. The varying thickness of the continuous conducting path of the radiofrequency coil 601 of Figure 6 will generate an oscillating magnetic field having a different shape to that generated by the radiofrequency coil 1 shown in Figures 1a and 1b, but will otherwise operate in a very similar manner.

It will be appreciated that many other shapes and configurations may be provided for conducting elements than is shown in Figures 5 and 6. For example, a tapered design may be applied to any of the radiofrequency coils shown in Figures 1-3. It will also be appreciated that many other tapered designs are possible in addition to the designs shown in Figures 5 and 6, e.g. designs with curved or stepped transition.

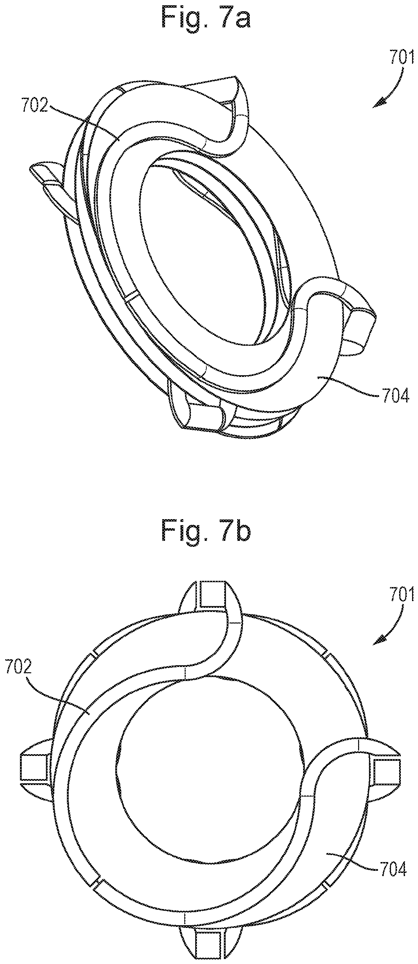

Figures 7a and 7b shows another radiofrequency coil 701 in accordance with an embodiment of the present invention. The shape of the radiofrequency coil 701 shown in Figure 7a and 7b is similar to the radiofrequency coil 2 shown in Figures 2a and 2b in that it has four conducting elements 702 each with an "omega (Ω)" shape. The radiofrequency coil 701 is set to have a diameter of 150 mm. The conducting elements 702 are cylindrical tubes comprising a circular cross-section with a uniform width of 10 mm along its length and a uniform wall thickness of 1 mm. Figure 7a shows the dielectric layers 704 of the radiofrequency coil 701 arranged such that the dielectric layers 704 are positioned between the crossing points of the conducting elements 702. For the purposes of clarity, the dielectric layers 704 are not shown in Figure 7b.

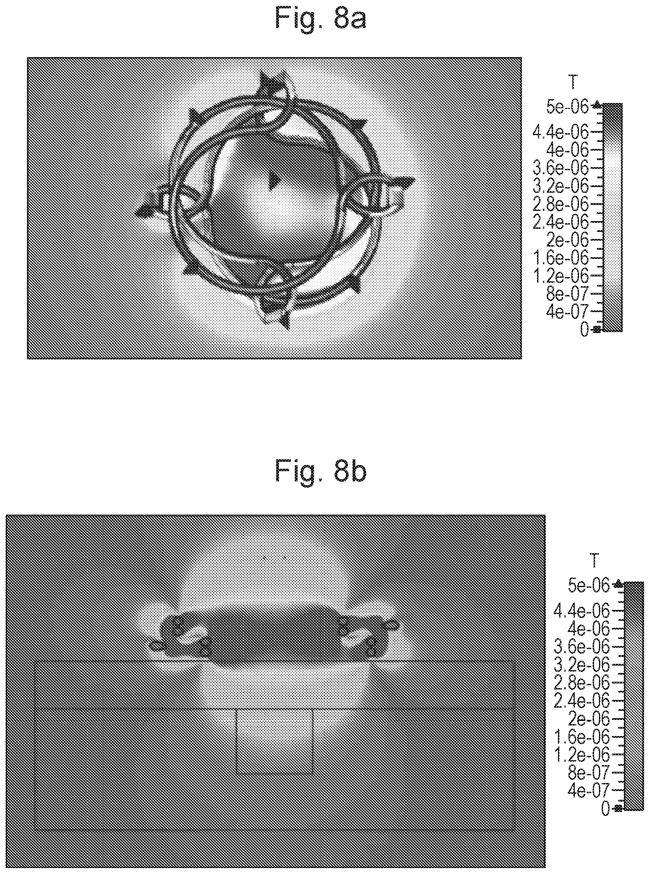

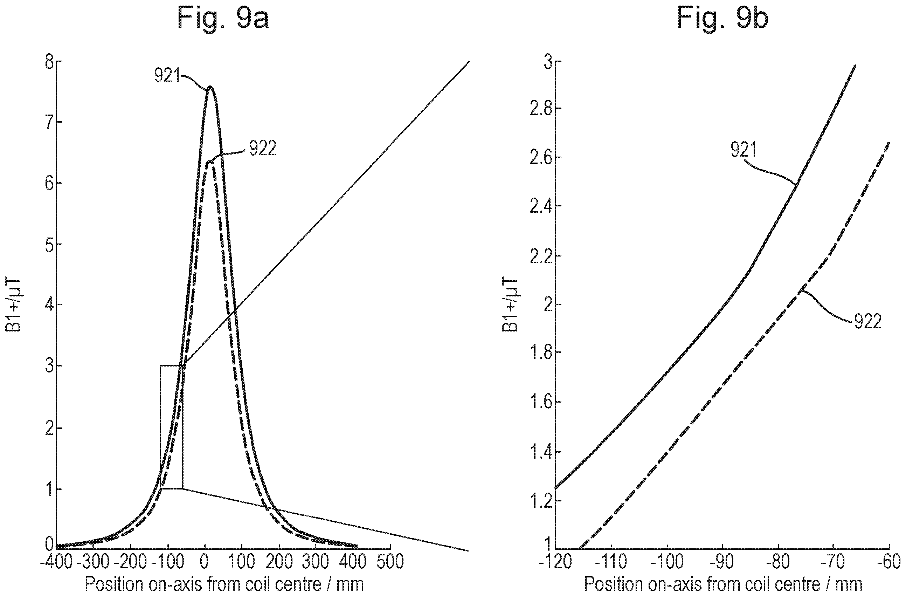

Frequency domain EM simulations were performed using the EM model radiofrequency coil 701. The transmit magnetic field, B₁+ was calculated from 1 W of simulated power. The relative signal-to-noise ratio (SNR) was calculated from B₁+. The results of this simulation are shown in Figures 8a to 8d and Figures 9a to 9d.

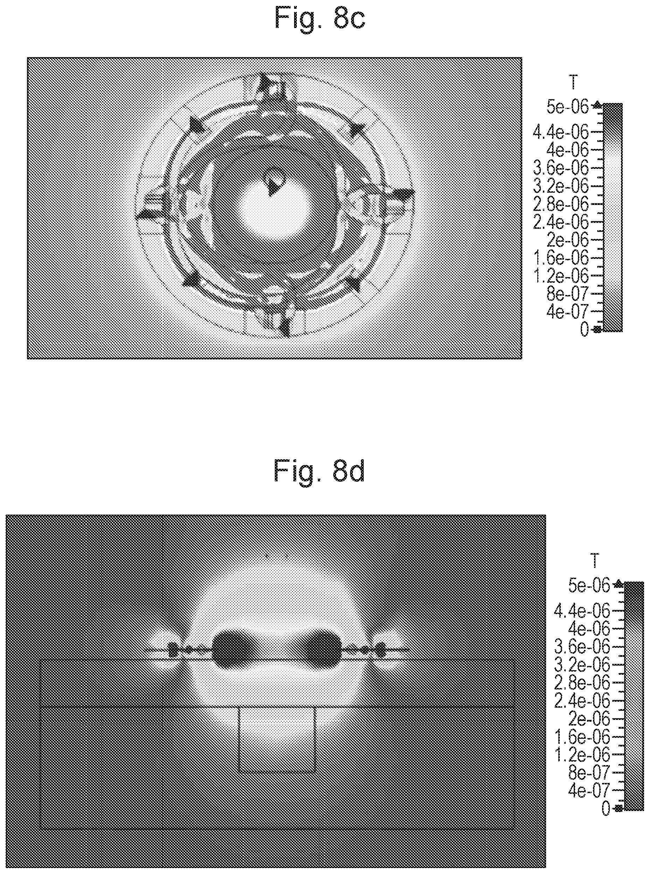

Figures 8a and 8b show the simulated surface (Figure 8a) and cross-section (Figure 8b) of the magnetic flux density (B,+) for the radiofrequency coil 701. Figures 8c and 8d show the simulated surface (Figure 8c) and cross-section (Figure 8d) of the magnetic flux density (B,+) for the radiofrequency coils having a comparative design to those shown in Figure 7a and 7b but comprising copper track conducting elements having a 10 mm uniform width.

The results shown in Figures 8a and 8b when compared to Figures 8c and 8d show that radiofrequency coils comprised of conducting elements with a cylindrical tube design have an improved B₁+ flux density profile compared to an equivalent radiofrequency coils having copper tracks, in spite of the fact that the centre of the radiofrequency coil with tubular conducting elements will be further away from the sample.

Figure 9a shows the on-axis simulated magnetic flux density (B,+) results shown in Figure 8a as a cross-section through the centre of the radiofrequency coil. Figure 9b shows an enlarged portion of Figure 9a at penetration depths of interest corresponding to the depth of key organs within the human body. The results clearly show that the strength of the B₁+ field for cylindrical tube conducting elements 921 is greater than that of the B₁+ field for copper track conducting elements 922 of an equivalent design at all penetration depths.

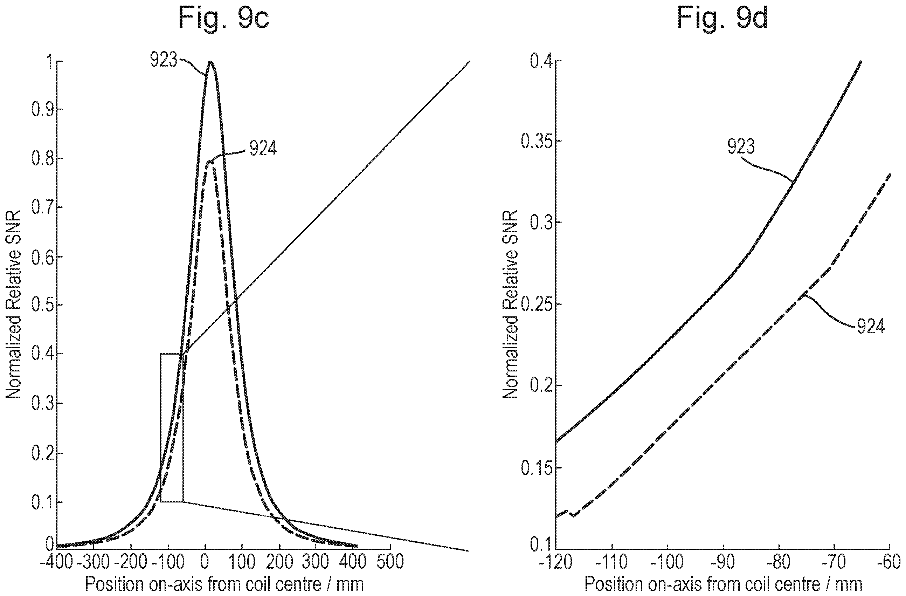

Figure 9c shows the on-axis simulated signal-to-noise ratio (SNR) corresponding to the results shown in Figures 8a and 8b. Figure 9d shows an enlarged portion of Figure 9c at penetration depths of interest corresponding to the depth of key organs within the human body. The results clearly show that the SNR for a radiofrequency coil comprising cylindrical tube conducting elements 923 is better than the SNR for a radiofrequency coil comprising copper track conducting elements 924 at all penetration depths.

The results shown in Figures 8a - 8d and 9a - 9d thus show that when compared to a copper track conductor design, cylindrical tube conductors help to improve both transmit and receive performance for radiofrequency surface coils due to the reduction in resistance due to proximity effects. However, radiofrequency coils comprising either cylindrical tube conductor elements or copper track conductor elements according to embodiments of the present invention help to provide an improved radiofrequency coil compared to those known in the art.

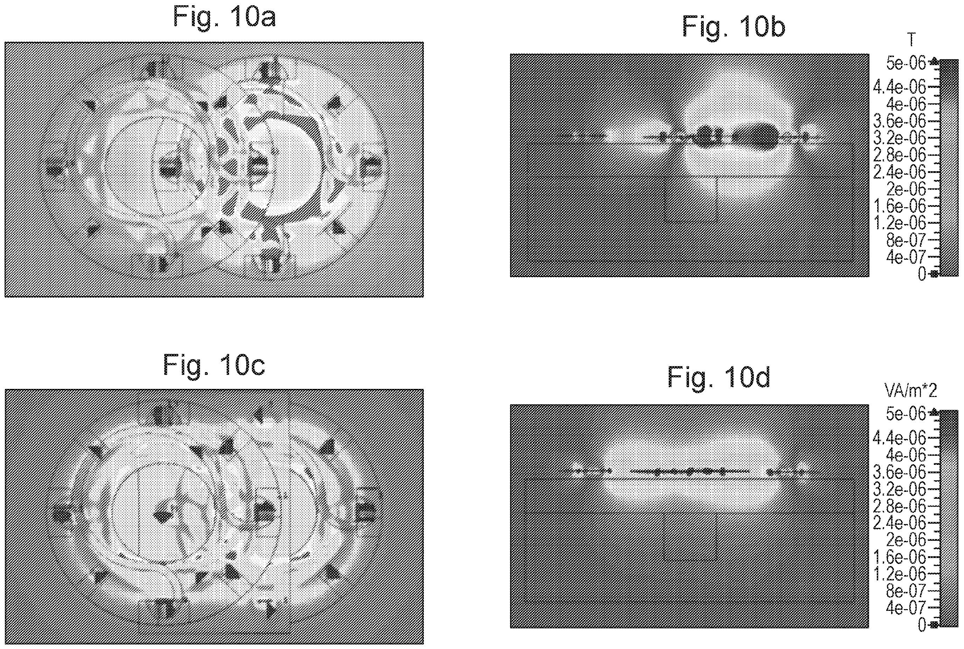

Figures 10a and 10b show a simulated surface (Figure 10a) and cross-section (Figure 10b) of the magnetic flux density (B₁+) for two overlapping radiofrequency coils at an optimised position (calculated, in this embodiment, to be a centre-to-centre distance of 134.2 mm). Only one of the two radiofrequency coils within the pair is excited in the simulation. The radiofrequency coils depicted are of the design shown in Figure 2a and 2b, e.g. the four conducting elements of an "omega" shape. The overlap distance was determined using frequency domain EM simulations where the overlap distance was scanned incrementally to find a minimum S₂₁ transmission parameter.

Figure 10c and 10d show a simulated surface (Figure 10c) and cross-section (Figure 10d) of the magnetic flux density (B₁+) for two overlapping radiofrequency coils at a position other than optimised overlap (in this example, 139 mm). Only one of the two radiofrequency coils within the pair is excited in the simulation. The radiofrequency coils depicted are of the design shown in Figure 2a and 2b, e.g. the four conducting elements of an "omega" shape.

Comparison of Figures 10a with 10c and 10b with 10d clearly shows that the system with optimised overlap (Figures 10a and 10b) has an improved inductive decoupling. The system shown in Figures 10c and 10d has a greater degree of coupling, with both radiofrequency coils becoming one resonant structure. This results in the optimised overlap system having an increased magnetic flux density peak strength and increased depth penetration.

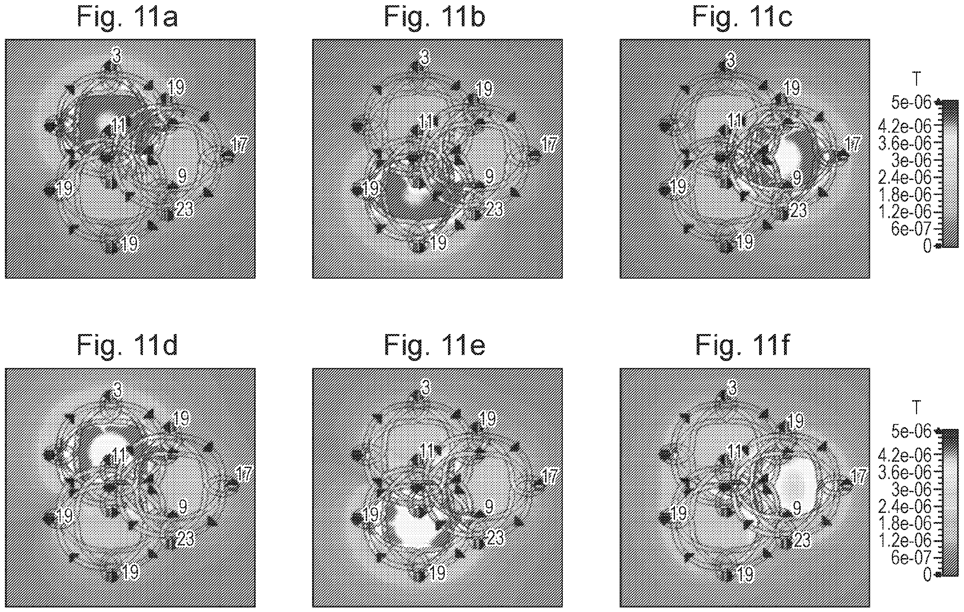

Figures 11a to 11c show a simulated surface of the magnetic flux density (B₁+) field for three overlapping radiofrequency coils at an optimised position of overlap where only one of the three radiofrequency coils within the system is excited. The radiofrequency coils depicted are of the design shown in Figure 2a and 2b, e.g. the four conducting elements of an "omega" shape. The optimised overlap distance between the first and second radiofrequency coil was approximated to be equal to the overlap distance determined via the simulations shown in Figures 10a and 10b (e.g. 134.2 mm). The distance between the first and third, and second and third radiofrequency coils was determined using frequency domain EM simulations where the overlap distance was scanned incrementally until a minimum for the S₃₂ and S₃₁ transmission parameters was found.

Figures 11d to 11f show a simulated surface of the magnetic flux density (B₁+) for three overlapping radiofrequency coils at a position other than optimal overlap where only one of the two radiofrequency coils within the pair is excited. The radiofrequency coils depicted are of the design shown in Figure 2a and 2b, e.g. the four conducting elements of an "omega" shape.

Comparison of the two data sets shown in Figures 11a-11c and 11d-11f again shows that, like the two coil system shown in Figures 10a - 10d, the three coil system has an improved inductive decoupling when the radiofrequency coils are arranged at a position of optimised overlap with a distance between coils 1 and 3 of 145 mm and a distance between coils 2 and 3 of 148 mm (Figure 11a-11c). In contrast, the un-optimised overlap system has increased coupling, with the three elements becoming one resonant structure, resulting in a reduced B₁+ depth penetration and peak strength.

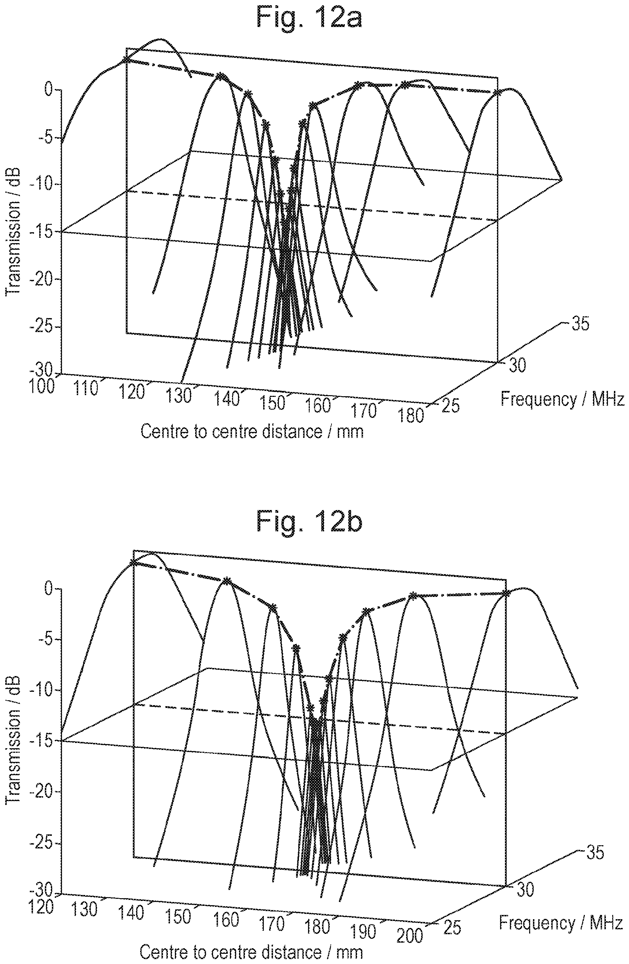

Figure 12a shows the simulated S₂₁ transmission parameter value of the two radiofrequency coil array system shown in Figures 10a - 10d as the overlap of the two radiofrequency coils is varied. Figure 12b shows the simulated S₂₁ parameter value of a system known in the prior art comprising two single "loop" type radiofrequency surface coils (e.g. radiofrequency surface coils of a single layered continuous circular conducting element). Comparison of Figure 12a and Figure 12b shows that the increased complexity of the radiofrequency coil surface (e.g. when compared to the simplicity of a single loop radiofrequency coil) does not result in a corresponding increase in difficulty in finding the optimum overlap for maximised decoupling.

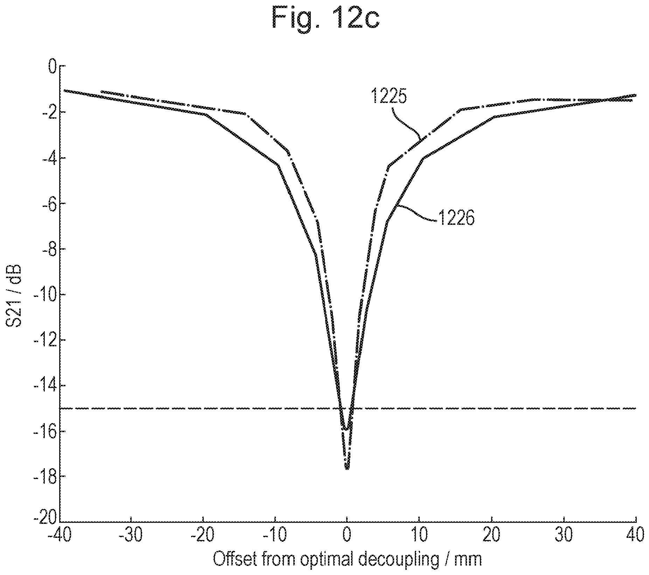

Figure 12c shows the simulated S₂₁ transmission parameter values shown in Figure 12a (for the two overlapping radiofrequency coil system in accordance with the embodiment of this invention shown in Figure 10a - 10d) and Figure 12b (for the prior art system comprising two overlapped single "loop" type radiofrequency surface coils). This comparison further shows that the simulation results for the overlapped radiofrequency coils of the present invention (comprising "omega (Ω)" shaped conducting elements) 1225 provides an improved extent of decoupling, with a value of -17.63 dB at an optimised overlap position. In comparison, the simulation results for the overlapping single "loop" system known in the prior art 1226 shows a minimum decoupling value of -15.96 dB. This shows that arrays comprising a plurality of surface radiofrequency coils in accordance with embodiments of the present invention help to provide an improved receive array, compared to arrays comprising surface coils known in the art, with an improved sensitivity and improved signal-to-noise ratio of each individual element within the array.

It will be seen from the above that in at least preferred embodiments, the present invention provides a radiofrequency coil which has a significant overlap between the elements of the continuous conducting path. This helps to provide a radiofrequency coil that can generate an increased magnetic flux density for transmitting into a sample and/or receive an emitted magnetic field with an improved sensitivity.

Although the embodiments show the radiofrequency coil formed from conducting elements having particular shapes and arrangements relative to each other, it will be appreciated that many other different shapes and configurations may be provided.

## Claims

1. A radiofrequency surface coil (1, 21, 31, 501, 601, 701) for magnetic resonance, wherein the radiofrequency surface coil (1, 21, 31, 501, 601, 701) is arranged to transmit and/or receive an oscillating magnetic field, the radiofrequency surface coil (1, 21, 31, 501, 601, 701) comprising:
a continuous conducting path comprising a plurality of conducting elements (2, 22, 32, 502, 602, 702), the continuous conducting path being conducting to an applied or induced radiofrequency alternating current, wherein each conducting element (2, 22, 32, 502, 602 702) is connected to another of the conducting elements (2, 22, 32, 502, 602, 702) so as to form the continuous conducting path, and each conducting element (2, 22, 32, 502, 602, 702) defines an area bounded by the conducting element (2, 22, 32, 502, 602, 702);
wherein each conducting element (2, 22, 32, 502, 602, 702) at least partially surrounds the area it bounds and the remainder of the area is bounded by a geodesic line extending between the ends of the conducting element (2, 22, 32, 502, 602, 702);
**characterised in that** the plurality of conducting elements (2, 22, 32, 502, 602, 702) are arranged in substantially parallel surfaces such that the area bounded by each conducting element (2, 22, 32, 502, 602, 702) overlaps with at least 20% of the area bounded by another of the conducting elements (2, 22, 32, 502, 602, 702); and
wherein each conducting element (2, 22, 32, 502, 602, 702) is separated from the conducting element (2, 22, 32, 502, 602, 702) in the adjacent substantially parallel surface by a dielectric (4, 24, 34, 504, 704).

2. The radiofrequency surface coil (1, 21, 31, 501, 601, 701) as claimed in claim 1, wherein the dielectric (4, 24, 34, 504, 704) is arranged at least between the locations where pairs of conducting elements (2, 22, 32, 502, 602, 702) cross over each other (6, 26, 36, 506, 606).

3. The radiofrequency surface coil (1, 21, 31, 501, 601, 701) as claimed in claim 1 or claim 2, wherein the plurality of conducting elements (2, 22, 32, 502, 602, 702) are arranged about a common central region of the radiofrequency surface coil (1, 21, 31, 501, 601, 701); and
optionally, wherein the plurality of conducting elements (2, 22, 32, 502, 602, 702) are confined to an annulus surrounding the common central region (8, 28, 38).

4. The radiofrequency surface coil (1, 21, 31, 501, 601, 701) as claimed in claim 3, wherein the dielectric (4, 24, 34, 504, 704) does not extend over at least part of the common central region (8, 28, 38) of the radiofrequency surface coil (1, 21, 31, 501, 601, 701).

5. The radiofrequency surface coil (1, 21, 31, 501, 601, 701) as claimed in any preceding claim, wherein the bounded areas of the plurality of conducting elements (2, 22, 32, 502, 602, 702) overlap with each other at a central axis of the radiofrequency surface coil (1, 21, 31, 501, 601, 701); and/or
wherein the plurality of conducting elements (2, 22, 32, 502, 602, 702) are arranged such that a common area of overlap for the areas bounded by the plurality of conducting elements (2, 22, 32, 502, 602, 702) is at least 10% of a total area over which the areas bounded by the plurality of conducting elements (2, 22, 32, 502, 602, 702) extend; and/or
wherein the plurality of conducting elements (2, 22, 32, 502, 602, 702) are arranged such that less than 40% of the total area enclosed by the continuous conducting path does not have an overlap of at least some of the bounded areas defined by the plurality of conducting elements (2, 22, 32, 502, 602, 702).

6. The radiofrequency surface coil (1, 21, 31, 501, 601, 701) as claimed in any one of the preceding claims, wherein at each of the overlaps of a pair of crossing conducting elements (2, 22, 32, 502, 602, 702) in the continuous conducting path, the conducting elements (2, 22, 32, 502, 602, 702) cross with an angle that is greater than 20°, e.g. greater than 30°, e.g. greater than 40°; and/or
wherein the plurality of conducting elements (2, 22, 32, 502, 602, 702) are arranged in a rotationally symmetric configuration; optionally, wherein the order of rotational symmetry is greater than or equal to the number of conducting elements (2, 22, 32, 502, 602, 702) that form the continuous conducting path; and/or
wherein at least some of the plurality of conducting elements (2, 22, 32, 502, 602, 702) comprise an open shape.

7. The radiofrequency surface coil (1, 21, 31, 501, 601, 701) as claimed in any one of the preceding claims, wherein each conducting element (2, 22, 32, 502, 602, 702) is connected to another of the conducting elements (2, 22, 32, 502, 602, 702) at a periphery of the continuous conducting path; and/or
wherein each conducting element (2, 22, 32, 502, 602, 702) is connected to another of the conducting elements (2, 22, 32, 502, 602, 702) by one or more discrete electrical components; and
optionally where the one or more discrete electrical components comprise one or more capacitors and/or one or more LC traps.

8. The radiofrequency surface coil (1, 21, 31, 501, 601, 701) as claimed in any one of the preceding claims, wherein the radiofrequency surface coil (1, 21, 31, 501, 601, 701) comprises at least three conducting elements (2, 22, 32, 502, 602, 702); and/or
wherein the plurality of conducting elements (2, 22, 32, 502, 602, 702) are arranged such that each conducting element (2, 22, 32, 502, 602, 702) is positioned at a rotated position relative to another of the conducting elements (2, 22, 32, 502, 602, 702); and/or
wherein each conducting element (2, 22, 32, 502, 602, 702) comprises one or more discrete electrical components arranged part way along the length of the conducting element (2, 22, 32, 502, 602, 702).

9. The radiofrequency surface coil (1, 21, 31, 501, 601, 701) as claimed in any one of the preceding claims, wherein the conducting elements (2, 22, 32, 502, 602, 702) are each arranged on a substrate; and/or
wherein the continuous conducting path is mounted on a mounting substrate; and/or
wherein the radiofrequency surface coil (1, 21, 31, 501, 601, 701) is curved.

10. The radiofrequency surface coil (1, 21, 31, 501, 601, 701) as claimed in any one of the preceding claims, wherein the conducting elements (2, 22, 32, 502, 602, 702) comprise copper tracks on a substrate; optionally wherein the copper tracks have a thickness between 10 µm and 150 µm, e.g. between 17.5 µm to 140 µm, e.g. 70 µm, e.g. 35 µm; or
wherein the conducting elements (2, 22, 32, 502, 602, 702) comprise tubes; optionally wherein the cylindrical tubes have a wall thickness of between 50 µm and 2 mm, e.g. between 100 µm and 1.5 mm, e.g. between 0.5 mm and 1 mm.

11. The radiofrequency surface coil (1, 21, 31, 501, 601, 701) as claimed in any one of the preceding claims, wherein the conducting elements (2, 22, 32, 502, 602, 702) have a substantially constant width along their length, wherein the substantially constant width is between 1 mm and 20 mm, e.g. between 5 mm and 15 mm, e.g. between 5 mm and 10 mm; or
wherein the conducting elements (2, 22, 32, 502, 602, 702) have a varying width along their length such that the conducting element (2, 22, 32, 502, 602, 702) is comprised of at least one thicker portion (512, 612) and at least one thinner portion (514, 614); optionally wherein the thinner portion (514, 614) is arranged to be positioned at least where the pair of crossing conducting elements (2, 22, 32, 502, 602, 702) overlap (6, 26, 36, 506, 606).

12. A plurality of radiofrequency surface coils (1, 21, 31, 501, 601, 701) each as claimed in any one of the preceding claims, wherein the plurality of radiofrequency surface coils (1, 21, 31, 501, 601, 701) are arranged to operate in combination with each other.

13. The plurality of radiofrequency surface coils (1, 21, 31, 501, 601, 701) as claimed in claim 12, wherein the radiofrequency surface coils (1, 21, 31, 501, 601, 701) are arranged to operate in a quadrature configuration or in an array configuration; and/or
wherein the radiofrequency surface coils (1, 21, 31, 501, 601, 701) are spatially separated from each other.

14. The plurality of radiofrequency surface coils (1, 21, 31, 501, 601, 701) as claimed in claim 12 or 13, wherein one or more coils of the plurality of radiofrequency surface coils (1, 21, 31, 501, 601, 701) are geometrically overlapped with one or more other coils of the plurality of radiofrequency surface coils (1, 21, 31, 501, 601, 701); and
optionally, wherein one or more pairs of overlapping radiofrequency surface coils (1, 21, 31, 501, 601, 701) have a centre-to-centre distance of between 33% to 100% of the diameter of the radiofrequency surface coils (1, 21, 31, 501, 601, 701); and
optionally, wherein the centre-to-centre distance of the pair of radiofrequency surface coils (1, 21, 31, 501, 601, 701) is equal to the position at which the smallest mutual inductance between the two radiofrequency surface coils (1, 21, 31, 501, 601, 701) is found.

15. The plurality of radiofrequency surface coils (1, 21, 31, 501, 601, 701) as claimed in any one of 12 to 14, wherein three or more radiofrequency surface coils (1, 21, 31, 501, 601, 701) are arranged in an array; and
optionally, wherein each of three radiofrequency surface coils (1, 21, 31, 501, 601, 701) overlaps with both of the other two radiofrequency surface coils (1, 21, 31, 501, 601, 701).

## Patentansprüche

1. Hochfrequenz-Oberflächenspule (1, 21, 31, 501, 601, 701) für Magnetresonanz, wobei die Hochfrequenz-Oberflächenspule (1, 21, 31, 501, 601, 701) dazu eingerichtet ist, ein oszillierendes Magnetfeld zu übertragen und/oder zu empfangen, wobei die Hochfrequenz-Oberflächenspule (1, 21, 31, 501, 601, 701) umfasst:
einen durchgehenden leitfähigen Pfad, der eine Vielzahl leitfähiger Elemente (2, 22, 32, 502, 602, 702) umfasst, wobei der durchgehende leitfähige Pfad für einen angelegten oder induzierten Hochfrequenz-Wechselstrom leitfähig ist, wobei jedes leitfähige Element (2, 22, 32, 502, 602, 702) mit einem anderen der leitfähigen Elemente (2, 22, 32, 502, 602, 702) verbunden ist, um den durchgehenden leitfähigen Pfad zu bilden, und jedes leitfähige Element (2, 22, 32, 502, 602, 702) eine Fläche definiert, die durch das leitfähige Element (2, 22, 32, 502, 602, 702) begrenzt ist;
wobei jedes leitfähige Element (2, 22, 32, 502, 602, 702) die von ihm begrenzte Fläche mindestens teilweise umgibt und der Rest der Fläche durch eine geodätische Linie begrenzt ist, die sich zwischen den Enden des leitfähigen Elements (2, 22, 32, 502, 602, 702) erstreckt;
**dadurch gekennzeichnet, dass** die Vielzahl leitfähiger Elemente (2, 22, 32, 502, 602, 702) in im Wesentlichen parallelen Oberflächen derart eingerichtet ist, dass die von jedem leitfähigen Element (2, 22, 32, 502, 602, 702) begrenzte Fläche sich mit mindestens 20 % der von einem anderen der leitfähigem Elemente (2, 22, 32, 502, 602, 702) begrenzten Fläche überlappt; und
wobei jedes leitfähige Element (2, 22, 32, 502, 602, 702) durch ein Dielektrikum (4, 24, 34, 504, 704) von dem leitfähigen Element (2, 22, 32, 502, 602, 702) in der benachbarten, im Wesentlichen parallelen Oberfläche getrennt ist.

2. Hochfrequenz-Oberflächenspule (1, 21, 31, 501, 601, 701) nach Anspruch 1, wobei das Dielektrikum (4, 24, 34, 504, 704) mindestens zwischen den Stellen eingerichtet ist, an denen sich Paare leitfähiger Elemente (2, 22, 32, 502, 602, 702) kreuzen (6, 26, 36, 506, 606).

3. Hochfrequenz-Oberflächenspule (1, 21, 31, 501, 601, 701) nach Anspruch 1 oder Anspruch 2, wobei die Vielzahl leitfähiger Elemente (2, 22, 32, 502, 602, 702) um einen gemeinsamen zentralen Bereich der Hochfrequenz-Oberflächenspule (1, 21, 31, 501, 601, 701) eingerichtet ist; und
wobei optional die Vielzahl leitfähiger Elemente (2, 22, 32, 502, 602, 702) auf einen Ring beschränkt ist, der den gemeinsamen zentralen Bereich (8, 28, 38) umgibt.

4. Hochfrequenz-Oberflächenspule (1, 21, 31, 501, 601, 701) nach Anspruch 3, wobei sich das Dielektrikum (4, 24, 34, 504, 704) nicht über mindestens einen Teil des gemeinsamen zentralen Bereichs (8, 28, 38) der Hochfrequenz-Oberflächenspule (1, 21, 31, 501, 601, 701) erstreckt.

5. Hochfrequenz-Oberflächenspule (1, 21, 31, 501, 601, 701) nach einem vorstehenden Anspruch, wobei die begrenzten Flächen der Vielzahl leitfähiger Elemente (2, 22, 32, 502, 602, 702) einander an einer Mittelachse der Hochfrequenz-Oberflächenspule (1, 21, 31, 501, 601, 701) überlappen; und/oder
wobei die Vielzahl leitfähiger Elementen (2, 22, 32, 502, 602, 702) derart eingerichtet ist, dass eine gemeinsame Überlappungsfläche für die durch die Vielzahl leitfähiger Elemente (2, 22, 32, 502, 602, 702) begrenzten Flächen mindestens 10 % einer Gesamtfläche beträgt, über die sich die durch die Vielzahl leitfähiger Elemente (2, 22, 32, 502, 602, 702) begrenzten Flächen erstrecken; und/oder
wobei die Vielzahl leitfähiger Elemente (2, 22, 32, 502, 602, 702) derart eingerichtet sind, dass weniger als 40 % der Gesamtfläche, die von dem kontinuierlichen leitfähigen Pfad umschlossen ist, keine Überlappung von mindestens einigen der begrenzten Flächen aufweisen, die durch die Vielzahl leitfähiger Elemente (2, 22, 32, 502, 602, 702) definiert sind.

6. Hochfrequenz-Oberflächenspule (1, 21, 31, 501, 601, 701) nach einem der vorstehenden Ansprüche, wobei an jeder der Überlappungen eines Paars sich kreuzender leitfähiger Elemente (2, 22, 32, 502, 602, 702) in dem kontinuierlichen leitfähigen Pfad sich die leitfähigen Elemente (2, 22, 32, 502, 602, 702) in einem Winkel kreuzen, der größer als 20°, z. B. größer als 30°, z. B. größer als 40° ist; und/oder
wobei die Vielzahl leitfähiger Elemente (2, 22, 32, 502, 602, 702) in einer rotationssymmetrischen Konfiguration eingerichtet ist; wobei optional die Größe der Rotationssymmetrie größer oder gleich der Anzahl leitfähiger Elemente (2, 22, 32, 502, 602, 702) ist, die den durchgehenden leitfähigen Pfad bilden; und/oder
wobei mindestens einige der Vielzahl leitfähiger Elemente (2, 22, 32, 502, 602, 702) eine offene Form umfassen.

7. Hochfrequenz-Oberflächenspule (1, 21, 31, 501, 601, 701) nach einem der vorstehenden Ansprüche, wobei jedes leitfähige Element (2, 22, 32, 502, 602, 702) an einem Rand des kontinuierlichen leitfähigen Pfades mit einem anderen der leitfähigen Elemente (2, 22, 32, 502, 602, 702) verbunden ist; und/oder
wobei jedes leitfähige Element (2, 22, 32, 502, 602, 702) durch eine oder mehrere diskrete elektrische Komponenten mit einem anderen der leitfähigen Elemente (2, 22, 32, 502, 602, 702) verbunden ist; und
wobei optional die eine oder mehreren diskreten elektrischen Komponenten einen oder mehrere Kondensatoren und/oder eine oder mehrere LC-Fallen umfassen.

8. Hochfrequenz-Oberflächenspule (1, 21, 31, 501, 601, 701) nach einem der vorstehenden Ansprüche, wobei die Hochfrequenz-Oberflächenspule (1, 21, 31, 501, 601, 701) mindestens drei leitfähige Elemente (2, 22, 32, 502, 602, 702) umfasst; und/oder
wobei die Vielzahl leitfähiger Elementen (2, 22, 32, 502, 602, 702) derart eingerichtet ist, dass jedes leitfähige Element (2, 22, 32, 502, 602, 702) in einer gedrehten Position relativ zu einem anderen der leitfähigen Elemente (2, 22, 32, 502, 602, 702) positioniert ist; und/oder
wobei jedes leitfähige Element (2, 22, 32, 502, 602, 702) eine oder mehrere diskrete elektrische Komponenten umfasst, die teilweise entlang der Länge des leitfähigen Elements (2, 22, 32, 502, 602, 702) eingerichtet sind.

9. Hochfrequenz-Oberflächenspule (1, 21, 31, 501, 601, 701) nach einem der vorstehenden Ansprüche, wobei die leitfähigen Elemente (2, 22, 32, 502, 602, 702) jeweils auf einem Substrat eingerichtet sind; und/oder
wobei der durchgehende leitfähige Pfad auf einem Montagesubstrat montiert ist; und/oder
wobei die Hochfrequenz-Oberflächenspule (1, 21, 31, 501, 601, 701) gekrümmt ist.

10. Hochfrequenz-Oberflächenspule (1, 21, 31, 501, 601, 701) nach einem der vorstehenden Ansprüche, wobei die leitfähigen Elemente (2, 22, 32, 502, 602, 702) Kupferbahnen auf einem Substrat umfassen; wobei die Kupferbahnen optional eine Dicke zwischen 10 µm und 150 µm, z. B. zwischen 17,5 µm und 140 µm, z. B. 70 µm, z. B. 35 µm, aufweisen; oder
wobei die leitfähigen Elemente (2, 22, 32, 502, 602, 702) Rohre umfassen; wobei optional die zylindrischen Rohre eine Wandstärke zwischen 50 µm und 2 mm, z. B. zwischen 100 µm und 1,5 mm, z. B. zwischen 0,5 mm und 1 mm aufweisen.

11. Hochfrequenz-Oberflächenspule (1, 21, 31, 501, 601, 701) nach einem der vorstehenden Ansprüche, wobei die leitfähigen Elemente (2, 22, 32, 502, 602, 702) entlang ihrer Länge eine im Wesentlichen konstante Breite aufweisen, wobei die im Wesentlichen konstante Breite zwischen 1 mm und 20 mm, z. B. zwischen 5 mm und 15 mm, z. B. zwischen 5 mm und 10 mm, beträgt; oder
wobei die leitfähigen Elemente (2, 22, 32, 502, 602, 702) entlang ihrer Länge eine variierende Breite derart aufweisen, dass das leitfähige Element (2, 22, 32, 502, 602, 702) mindestens einen dickeren Abschnitt (512, 612) und mindestens einen dünneren Abschnitt (514, 614) umfasst; wobei optional der dünnere Abschnitt (514, 614) derart eingerichtet ist, dass er mindestens dort positioniert ist, wo sich das Paar sich kreuzender leitfähiger Elemente (2, 22, 32, 502, 602, 702) überlappt (6, 26, 36, 506, 606).

12. Vielzahl von Hochfrequenz-Oberflächenspulen (1, 21, 31, 501, 601, 701), jeweils nach einem der vorstehenden Ansprüche, wobei die Vielzahl von Hochfrequenz-Oberflächenspulen (1, 21, 31, 501, 601, 701) dazu eingerichtet ist, in Kombination miteinander zu arbeiten.

13. Vielzahl von Hochfrequenz-Oberflächenspulen (1, 21, 31, 501, 601, 701) nach Anspruch 12, wobei die Hochfrequenz-Oberflächenspulen (1, 21, 31, 501, 601, 701) dazu eingerichtet sind, in einer Quadraturkonfiguration oder in einer Array-Konfiguration zu arbeiten; und/oder
wobei die Hochfrequenz-Oberflächenspulen (1, 21, 31, 501, 601, 701) räumlich voneinander getrennt sind.

14. Vielzahl von Hochfrequenz-Oberflächenspulen (1, 21, 31, 501, 601, 701) nach Anspruch 12 oder 13, wobei eine oder mehrere Spulen der Vielzahl von Hochfrequenz-Oberflächenspulen (1, 21, 31, 501, 601, 701) geometrisch mit einer oder mehreren anderen Spulen der Vielzahl von Hochfrequenz-Oberflächenspulen (1, 21, 31, 501, 601, 701) überlappen; und
wobei optional ein oder mehrere Paare einander überlappender Hochfrequenz-Oberflächenspulen (1, 21, 31, 501, 601, 701) einen Mittenabstand zwischen 33 % und 100 % des Durchmessers der Hochfrequenz-Oberflächenspulen (1, 21, 31, 501, 601, 701) aufweisen; und
wobei optional der Mittenabstand des Paars von Hochfrequenz-Oberflächenspulen (1, 21, 31, 501, 601, 701) gleich der Position ist, an der die kleinste gegenseitige Induktivität zwischen den beiden Hochfrequenz-Oberflächenspulen (1, 21, 31, 501, 601, 701) vorgefunden wird.

15. Vielzahl von Hochfrequenz-Oberflächenspulen (1, 21, 31, 501, 601, 701) nach einem der Ansprüche 12 bis 14, wobei drei oder mehr Hochfrequenz-Oberflächenspulen (1, 21, 31, 501, 601, 701) in einem Array eingerichtet sind; und
wobei optional jede der drei Hochfrequenz-Oberflächenspulen (1, 21, 31, 501, 601, 701) mit den beiden der anderen zwei Hochfrequenz-Oberflächenspulen (1, 21, 31, 501, 601, 701) überlappt.

## Revendications

1. Bobine de surface radiofréquence (1, 21, 31, 501, 601, 701) pour une résonance magnétique, dans laquelle la bobine de surface radiofréquence (1, 21, 31, 501, 601, 701) est agencée pour transmettre et/ou recevoir un champ magnétique oscillant, la bobine de surface radiofréquence (1, 21, 31, 501, 601, 701) comprenant :
un trajet conducteur continu comprenant une pluralité d'éléments conducteurs (2, 22, 32, 502, 602, 702), le trajet conducteur continu étant conducteur d'un courant alternatif radiofréquence appliqué ou induit, dans laquelle chaque élément conducteur (2, 22, 32, 502, 602, 702) est raccordé à un autre des éléments conducteurs (2, 22, 32, 502, 602, 702) de manière à former le trajet conducteur continu, et chaque élément conducteur (2, 22, 32, 502, 602, 702) définit une zone délimitée par l'élément conducteur (2, 22, 32, 502, 602, 702) ;
dans laquelle chaque élément conducteur (2, 22, 32, 502, 602, 702) entoure au moins partiellement la zone qu'il délimite, et le reste de la zone est délimité par une ligne géodésique s'étendant entre les extrémités de l'élément conducteur (2, 22, 32, 502, 602, 702) ;
**caractérisée en ce que** la pluralité d'éléments conducteurs (2, 22, 32, 502, 602, 702) est agencée sur des surfaces sensiblement parallèles de telle sorte que la zone délimitée par chaque élément conducteur (2, 22, 32, 502, 602, 702) chevauche au moins 20 % de la zone délimitée par un autre des éléments conducteurs (2, 22, 32, 502, 602, 702) ; et
dans laquelle chaque élément conducteur (2, 22, 32, 502, 602, 702) est séparé de l'élément conducteur (2, 22, 32, 502, 602, 702) dans la surface adjacente sensiblement parallèle par un diélectrique (4, 24, 34, 504, 704).

2. Bobine de surface radiofréquence (1, 21, 31, 501, 601, 701) selon la revendication 1, dans laquelle le diélectrique (4, 24, 34, 504, 704) est agencé au moins entre les emplacements où des paires d'éléments conducteurs (2, 22, 32, 502, 602, 702) se croisent (6, 26, 36, 506, 606).

3. Bobine de surface radiofréquence (1, 21, 31, 501, 601, 701) selon la revendication 1 ou la revendication 2, dans laquelle la pluralité d'éléments conducteurs (2, 22, 32, 502, 602, 702) est agencée autour d'une région centrale commune de la bobine de surface radiofréquence (1, 21, 31, 501, 601, 701) ; et
facultativement, dans laquelle la pluralité d'éléments conducteurs (2, 22, 32, 502, 602, 702) est confinée à un anneau entourant la région centrale commune (8, 28, 38).

4. Bobine de surface radiofréquence (1, 21, 31, 501, 601, 701) selon la revendication 3, dans laquelle le diélectrique (4, 24, 34, 504, 704) ne s'étend pas sur au moins une partie de la région centrale commune (8, 28, 38) de la bobine de surface radiofréquence (1, 21, 31, 501, 601, 701).

5. Bobine de surface radiofréquence (1, 21, 31, 501, 601, 701) selon une quelconque revendication précédente, dans laquelle les zones délimitées de la pluralité d'éléments conducteurs (2, 22, 32, 502, 602, 702) se chevauchent les unes les autres au niveau d'un axe central de la bobine de surface radiofréquence (1, 21, 31, 501, 601, 701) ; et/ou
dans laquelle la pluralité d'éléments conducteurs (2, 22, 32, 502, 602, 702) est agencée de telle sorte qu'une zone commune de chevauchement pour les zones délimitées par la pluralité d'éléments conducteurs (2, 22, 32, 502, 602, 702) soit au moins 10 % d'une zone totale sur laquelle les zones délimitées par la pluralité d'éléments conducteurs (2, 22, 32, 502, 602, 702) s'étendent ; et/ou
dans laquelle la pluralité d'éléments conducteurs (2, 22, 32, 502, 602, 702) est agencée de telle sorte que moins de 40 % de la surface totale entourée par le trajet conducteur continu ne présente pas de chevauchement d'au moins certaines des zones délimitées définies par la pluralité d'éléments conducteurs (2, 22, 32, 502, 602, 702).

6. Bobine de surface radiofréquence (1, 21, 31, 501, 601, 701) selon l'une quelconque des revendications précédentes, dans laquelle à chacun des chevauchements d'une paire d'éléments conducteurs croisés (2, 22, 32, 502, 602, 702) dans le trajet conducteur continu, les éléments conducteurs (2, 22, 32, 502, 602, 702) se croisent avec un angle qui est supérieur à 20°, par ex. supérieur à 30°, par ex. supérieur à 40° ; et/ou
dans laquelle la pluralité d'éléments conducteurs (2, 22, 32, 502, 602, 702) est agencée dans une configuration à symétrie de rotation ; facultativement, dans laquelle l'ordre de symétrie de rotation est supérieur ou égal au nombre d'éléments conducteurs (2, 22, 32, 502, 602, 702) qui forment le trajet conducteur continu ; et/ou
dans laquelle au moins certains éléments conducteurs de la pluralité d'éléments conducteurs (2, 22, 32, 502, 602, 702) comprennent une forme ouverte.

7. Bobine de surface radiofréquence (1, 21, 31, 501, 601, 701) selon l'une quelconque des revendications précédentes, dans laquelle chaque élément conducteur (2, 22, 32, 502, 602, 702) est raccordé à un autre des éléments conducteurs (2, 22, 32, 502, 602, 702) à une périphérie du trajet conducteur continu ; et/ou
dans laquelle chaque élément conducteur (2, 22, 32, 502, 602, 702) est raccordé à un autre des éléments conducteurs (2, 22, 32, 502, 602, 702) par un ou plusieurs composants électriques discrets ; et
facultativement lorsque les un ou plusieurs composants électriques discrets comprennent un ou plusieurs condensateurs et/ou un ou plusieurs pièges LC.

8. Bobine de surface radiofréquence (1, 21, 31, 501, 601, 701) selon l'une quelconque des revendications précédentes, dans laquelle la bobine de surface radiofréquence (1, 21, 31, 501, 601, 701) comprend au moins trois éléments conducteurs (2, 22, 32, 502, 602, 702) ; et/ou
dans laquelle la pluralité d'éléments conducteurs (2, 22, 32, 502, 602, 702) est agencée de telle sorte que chaque élément conducteur (2, 22, 32, 502, 602, 702) soit positionné dans une position tournée par rapport à un autre des éléments conducteurs (2, 22, 32, 502, 602, 702) ; et/ou
dans laquelle chaque élément conducteur (2, 22, 32, 502, 602, 702) comprend un ou plusieurs composants électriques discrets agencés en chemin le long de la longueur de l'élément conducteur (2, 22, 32, 502, 602, 702).

9. Bobine de surface radiofréquence (1, 21, 31, 501, 601, 701) selon l'une quelconque des revendications précédentes, dans laquelle les éléments conducteurs (2, 22, 32, 502, 602, 702) sont chacun agencés sur un substrat ; et/ou
dans laquelle le trajet conducteur continu est monté sur un substrat de montage ; et/ou
dans laquelle la bobine de surface radiofréquence (1, 21, 31, 501, 601, 701) est incurvée.

10. Bobine de surface radiofréquence (1, 21, 31, 501, 601, 701) selon l'une quelconque des revendications précédentes, dans laquelle les éléments conducteurs (2, 22, 32, 502, 602, 702) comprennent des pistes de cuivre sur un substrat ; facultativement dans laquelle les pistes de cuivre présentent une épaisseur entre 10 µm et 150 µm, par ex. entre 17,5 µm et 140 µm, par ex. 70 µm, par ex. 35 µm ; ou
dans laquelle les éléments conducteurs (2, 22, 32, 502, 602, 702) comprennent des tubes ; facultativement dans laquelle les tubes cylindriques présentent une épaisseur de paroi entre 50 µm et 2 mm, par ex. entre 100 µm et 1,5 mm, par ex. entre 0,5 mm et 1 mm.

11. Bobine de surface radiofréquence (1, 21, 31, 501, 601, 701) selon l'une quelconque des revendications précédentes, dans laquelle les éléments conducteurs (2, 22, 32, 502, 602, 702) présentent une largeur sensiblement constante sur leur longueur, dans laquelle la largeur sensiblement constante est entre 1 mm et 20 mm, par ex. entre 5 mm et 15 mm, par ex. entre 5 mm et 10 mm ; ou
dans laquelle les éléments conducteurs (2, 22, 32, 502, 602, 702) présentent une largeur variable le long de leur longueur de telle sorte que l'élément conducteur (2, 22, 32, 502, 602, 702) soit composé d'au moins une partie plus épaisse (512, 612) et d'au moins une partie plus mince (514, 614) ; facultativement dans laquelle la partie plus mince (514, 614) est agencée pour être positionnée au moins là où la paire d'éléments conducteurs croisés (2, 22, 32, 502, 602, 702) se chevauche (6, 26, 36, 506, 606).

12. Pluralité de bobines de surface radiofréquence (1, 21, 31, 501, 601, 701), chacune selon l'une quelconque des revendications précédentes, dans laquelle la pluralité de bobines de surface radiofréquence (1, 21, 31, 501, 601, 701) est agencée pour fonctionner en combinaison les unes avec les autres.

13. Pluralité de bobines de surface radiofréquence (1, 21, 31, 501, 601, 701) selon la revendication 12, dans laquelle les bobines de surface radiofréquence (1, 21, 31, 501, 601, 701) sont agencées pour fonctionner dans une configuration en quadrature ou dans une configuration en réseau ; et/ou
dans laquelle les bobines de surface radiofréquence (1, 21, 31, 501, 601, 701) sont spatialement séparées les unes des autres.

14. Pluralité de bobines de surface radiofréquence (1, 21, 31, 501, 601, 701) selon la revendication 12 ou 13, dans laquelle une ou plusieurs bobines de la pluralité de bobines de surface radiofréquence (1, 21, 31, 501, 601, 701) se chevauchent géométriquement avec une ou plusieurs autres bobines de la pluralité de bobines de surface radiofréquence (1, 21, 31, 501, 601, 701) ; et
facultativement, dans laquelle une ou plusieurs paires de bobines de surface radiofréquence se chevauchant (1, 21, 31, 501, 601, 701) présentent une distance centre à centre entre 33 % et 100 % du diamètre des bobines de surface radiofréquence (1, 21, 31, 501, 601, 701) ; et
facultativement, dans laquelle la distance centre à centre de la paire de bobines de surface radiofréquence (1, 21, 31, 501, 601, 701) est égale à la position à laquelle la plus petite inductance mutuelle entre les deux bobines de surface radiofréquence (1, 21, 31, 501, 601, 701) se trouve.

15. Pluralité de bobines de surface radiofréquence (1, 21, 31, 501, 601, 701) selon l'une quelconque des revendications 12 à 14, dans laquelle trois, ou plus, bobines de surface radiofréquence (1, 21, 31, 501, 601, 701) sont agencées en un réseau ; et
facultativement, dans laquelle chacune des trois bobines de surface radiofréquence (1, 21, 31, 501, 601, 701) chevauche l'une et l'autre des deux autres bobines de surface radiofréquence (1, 21, 31, 501, 601, 701).
